# EUROPÄISCHE PATENTSCHRIFT

(11) **EP 3 810 868 B1**
(45) Veröffentlichungstag und Bekanntmachung des Hinweises auf die Patenterteilung: **01.06.2022**
(21) Anmeldenummer: 20702401.9
(22) Anmeldetag: 27.01.2020
(51) Int. Cl.: E04F 15/02, E04F 15/18, E04F 15/10, E04F 13/076, E04F 13/077, E04F 13/08, E04F 13/16, E04F 13/18

(54) **BELAGSELEMENT**
COVERING ELEMENT
ÉLÉMENT DE REVÊTEMENT

(30) Priorität: 28.01.2019 DE 102019000561; 25.04.2019 DE 102019110650
(43) Veröffentlichungstag der Anmeldung: 28.04.2021
(73) Patentinhaber: Parador GmbH, 48653 Coesfeld (DE)
(72) Erfinder: PETERSEN, Frank, 48653 Coesfeld (DE)
(74) Vertreter: Weidener, Jörg Michael
(86) Internationale Anmeldenummer: PCT/EP2020/051913
(87) Internationale Veröffentlichungsnummer: WO 2020/156997

(56) Entgegenhaltungen:
- EP-A1- 0 940 518
- WO-A1-2005/049937
- FR-A1- 2 637 932

## Beschreibung

Die vorliegende Erfindung betrifft ein Belagselement, insbesondere eine Diele, das zur Verwendung als Boden-, Wand- und/oder Deckenbelagselement zur Bildung eines Boden-, Wand- und/oder Deckenbelages vorgesehen ist. Das Belagselement weist wenigstens eine Trägerplatte und wenigstens eine Funktionsschicht auf. Die Trägerplatte weist eine einer Nutzseite zugewandte Oberseite und eine der Oberseite gegenüberliegende, dem Untergrund zugewandte Unterseite auf.

Der Belag kann unmittelbar oder mittelbar auf dem Untergrund verlegt werden.

Im Stand der Technik ist es bekannt, Funktionsschichten, die insbesondere eine elektrische Funktionalität bereitstellen, in den oberen Schichtaufbau des Belagselementes zu integrieren. Durch die Funktionsschicht können unterschiedliche Eigenschaften des Belagselementes hervorgerufen und/oder unterschiedliche physikalische Kerngrößen gemessen werden, beispielsweise Temperatur, Feuchtigkeit oder Druck.

Allerdings ist im Stand der Technik nachteilig, dass eine elektrische Funktionalität letztlich mit einem hohen Aufwand in der Produktion und der anschließenden Verlegung verbunden ist. So müssen zum einen alle Belagselemente untereinander über Kabelverbindungen verbunden werden. Zum anderen ist es bekannt, die Funktionsschicht oberhalb der Trägerplatte anzuordnen, insbesondere wenn als Funktionsschicht eine Leuchtschicht vorgesehen ist. Von Nachteil bei dieser Anordnung ist wiederum, dass eine Kontaktierung von miteinander verbundenen Belagselementen nur schwer sichergestellt werden kann.

Darüber hinaus sind die elektrischen Verbindungen der Funktionsschichten in der Praxis Verschmutzungen, mechanischen Beanspruchungen durch oberseitige mechanische Einwirkungen und/oder werkstoffbedingten Schwindungsprozesse und/oder Feuchtigkeit ausgesetzt, wodurch die Lebensdauer der elektrischen Funktionalität der Funktionsschicht herabgesetzt und/oder die elektrische Kontaktierung miteinander verbundener Belagselemente gestört, ggf. sogar unterbrochen, wird.

Ferner erzeugen die aus dem Stand der Technik bekannten Funktionsschichten eine Reliefstruktur bzw. eine Oberflächenstruktur an der Nutzseite des Belagselementes, die sich nach einer gewissen Benutzungszeit, beispielsweise nach mehreren Monaten, abzeichnet. Eine derartige Reliefstruktur wird von einem Benutzer als störend wahrgenommen, wobei gleichzeitig auch eine Beschädigung der Funktionsschicht durch eine erhöhte, punktuelle Beanspruchung nicht ausgeschlossen werden kann.

Schließlich ist die Herstellung von Funktionsschicht(en) aufweisenden Belagselementen mit einer Vielzahl von Schwierigkeiten und herstellungstechnischen Herausforderungen verbunden, insbesondere da bei Verbinden der einzelnen Schichten des Belagselementes sichergestellt werden muss, dass keine Beschädigung der Funktionsschicht erfolgt.

Die EP 0 940 518 A1 betrifft ein Verkleidungselement zum Verkleiden von Gebäudeelementen, wobei das Verkleidungselement einen Grundkörper aufweist, auf dessen Vorderseite eine Decklage aus dünnem, flexiblem Material aufgebracht ist.

Die FR 2 637 932 A1 betrifft ein Belagselement, insbesondere Bodenbelagselement.

Die WO 2005/049937 A1 betrifft ein Panel für eine Mehrzahl von Paneelen aufweisendem Belag.

Die Aufgabe der vorliegenden Erfindung ist es nun, die aus dem Stand der Technik bekannten Nachteile zu vermeiden oder aber zumindest im Wesentlichen zu reduzieren.

Die vorgenannte Aufgabe wird erfindungsgemäß bei einem Belagselement der eingangs genannten Art dadurch gelöst, dass die Funktionsschicht auf einer an der Unterseite der Trägerplatte angeordneten Trägerschicht angeordnet ist, und dass an der Trägerschicht wenigstens zwei Leiterbahnen der Funktionsschicht angeordnet sind. Dabei steht die Funktionsschicht an wenigstens einer Längsseite im Einbauzustand des Belagselements über den Seitenrand der Längsseite über.

Als Seitenrand wird erfindungsgemäß die äußerste Kante der Unterseite der Trägerplatte verstanden. Über jenen Seitenrand steht die Funktionsschicht im Einbauzustand bzw. im verbauten Zustand des Belagselements über bzw. erstreckt sich über diesen hinaus.

Als Einbauzustand wird dabei derjenige Zustand des Belagselementes verstanden, bei dem bzw. in dem das Belagselement mit wenigstens einem weiteren Belagselement verbunden ist.

Erfindungsgemäß versteht es sich, dass die Funktionsschicht auch nur bereichsweise, vorzugsweise in Kontaktierungsbereichen, im Einbauzustand über den Seitenrand des Belagselements übersteht. Dabei kann insbesondere eine Mehrzahl von die überstehende Funktionsschicht bildenden Bereichen vorgesehen sein.

Dabei kann vorgesehen sein, dass die Funktionsschicht unmittelbar oder mittelbar mit der Trägerplatte, vorzugsweise fest, verbunden ist. Die unmittelbare Verbindung bedeutet dabei, dass die Funktionsschicht direkt an der Unterseite der Trägerplatte befestigt ist, während bei der mittelbaren Verbindung wenigstens eine Zwischenlage bzw. -schicht vorgesehen ist.

Insbesondere kann die Funktionsschicht einteilig - das heißt als eine einzige zusammenhängende Schicht - und/oder mehrteilig ausgebildet sein. Vorzugsweise weist die Funktionsschicht wenigstens zwei miteinander verbundene Schichten oder wenigstens zwei voneinander elektrisch isolierte und/oder getrennte Bereiche auf.

Erfindungsgemäß ist insbesondere vorgesehen, dass die Funktionsschicht an wenigstens einer Längsseite bereits vor Einbau über den Seitenrand der Seite übersteht. Die Funktionsschicht kann demgemäß im "separierten" bzw. "vereinzelten" Zustand des Belagselementes über den Seitenrand überstehen.

Durch die erfindungsgemäße Lösung kann eine Vielzahl von Vorteilen erreicht werden:
Zum einen kann die Integration der eine insbesondere eine elektrische Funktionalität bereitstellenden Funktionsschicht sowohl kostengünstig als auch sehr einfach ermöglicht werden.

Zum anderen stellt eine erfindungsgemäße elektrische und/oder induktive Kontaktierung/Kopplung, die über den überstehenden Bereich der Funktionsschicht erfolgt, eine vor Schmutz und/oder Feuchtigkeit geschützte Kopplung der Funktionsschichten von miteinander verbundenen Belagselementen sicher.

Durch die erfindungsgemäße unterseitige Anordnung der Funktionsschicht gelingt es, die Funktionsschicht vor Verschmutzungen und/oder Feuchtigkeit zu schützen. Die auf die Nutzseite einwirkenden Beanspruchungen, insbesondere Feuchtigkeit, können zumindest im Wesentlichen von der Funktionsschicht ferngehalten werden.

Darüber hinaus gelingt es durch die unterseitige Anordnung der Funktionsschicht und der vereinfachten Kontaktierung der Funktionsschichten benachbarter und miteinander verbundener Belagselemente mittels des überstehenden Bereiches, dass letztlich die Anordnung der Funktionsschicht und insbesondere die Bereitstellung der, vorzugsweise elektrischen, Funktionalität losgelöst von der Herstellung des Belagselementes erfolgen kann. Dies verringert u.a. die Produktionskosten, da an bereits hergestellte Belagselemente die Funktionsschicht angebracht, insbesondere aufkaschiert und/oder aufgeklebt, werden kann. Hierdurch reduzieren sich die Herstellungs- und Lagerkosten, insbesondere wobei keine eigene Fertigungslinie für das die Funktionsschicht aufweisende Belagselement von Nöten ist.

Erfindungsgemäß ist alternativ oder zusätzlich möglich, dass die Funktionsschicht in den Schichtaufbau des Belagselementes während dessen Herstellung angeordnet werden kann. In diesem Zusammenhang kann vorgesehen sein, dass unterhalb der Funktionsschicht, der Nutzseite abgewandt, weitere Schichten, beispielsweise ein Gegenzug und/oder eine Dämmschicht, anordenbar sind, insbesondere fest mit der Funktionsschicht verbindbar sind.

Erfindungswesentlich ist in diesem Zusammenhang, dass die Funktionsschicht unterhalb der Trägerplatte angeordnet ist. Sie kann entweder unmittelbar oder mittelbar an die Trägerplatte angrenzen und/oder mit der Trägerplatte verbunden sein. Insbesondere kann die Funktionsschicht auch gedruckt werden, vorzugsweise zur Gewährleistung individueller Vorgaben für einzelne Belagselemente.

Außerdem wird eine aufwendige manuelle Verkabelung der einzelnen Belagselemente untereinander vermieden. Die Kontaktierung von miteinander zu verbindenden Belagselementen, insbesondere die Kontaktierung und/oder Kopplung der Funktionsschichten der miteinander zu verbindenden Belagselemente, kann durch den überlappenden/überstehenden Bereich der Funktionsschicht gewährleistet werden, vorzugsweise ohne dass beim Verlegen eine - zusätzlich zur Verbindung der Belagselemente vorgesehene - manuelle Verbindung, beispielsweise eine Verkabelung, der Funktionsschichten erfolgen muss.

Letztlich werden die Funktionsschichten durch ein "Aufeinanderpressen" bzw. "Aufeinanderdrücken" miteinander verbunden, wobei der hierfür benötigte Druck durch die miteinander verbundenen Trägerplatten sichergestellt werden kann. Folglich kann eine Verlegung von Funktionsschichten aufweisenden Belagselementen auch durch Laien durchgeführt werden, wobei das Verlegeverfahren einfach umsetzbar ist. Dies ermöglicht dem Nutzer die kostengünstige und einfache Verlegung eines eine Funktionsschicht aufweisenden Belags, wobei bei der Verlegung nicht notwendigerweise auf einen Fachmann zurückgegriffen werden muss.

Eine als störend wahrnehmbare Reliefstruktur bzw. Oberflächenstruktur, die durch eine oberseitig auf der Trägerplatte angeordnete Funktionsschicht hervorgerufen wird, kann erfindungsgemäß vermieden werden. Die Strukturen der Funktionsschicht zeichnen sich zumindest im Wesentlichen nicht auf der Nutzseite des Belagselementes ab, da die Trägerplatte eine ausreichende Stabilität, Festigkeit und/oder Härte aufweist, so dass sich die Strukturen bzw. Höhenunterschiede der Funktionsschicht nicht in der Oberseite der Trägerplatte und folglich auch nicht auf der Nutzseite wiederspiegeln. Der ästhetische Eindruck und die optische Wahrnehmung des Belagselementes werden demgemäß nicht durch die Verwendung einer Funktionsschicht beeinträchtigt, was letztlich auch die Haptik des gesamten Belagselementes verbessert.

Alternativ oder zusätzlich kann vorgesehen sein, dass Unebenheiten des Untergrundes und/oder der Trägerplatte durch einen Unterboden und/oder eine unterseitige Ausgleichsschicht ausgeglichen werden, insbesondere wobei eine sogenannte schwimmende Verlegung der Belagselemente auf den Untergrund ermöglicht wird.

Darüber hinaus kann die Stabilität, die Steifigkeit und/oder die Festigkeit des Belagselementes durch die Anordnung der Funktionsschicht unterhalb der Trägerplatte im Vergleich zu aus dem Stand der Technik bekannten Belagselementen erhöht werden. Letztlich kann die Funktionsschicht, insbesondere gemeinsam mit dem Gegenzug und/oder als Gegenzug, die Biegebeanspruchungen und/oder die Biegekräfte, die auf das Belagselement, insbesondere auf die Trägerplatte einwirken, ausgleichen. Dadurch kann eine Verformung und/oder Verbiegung des Belagselementes besser vermieden werden.

Des Weiteren ist die mit der Funktionsfläche ausgestattete Fläche eines Belages nicht nur einfach verlegbar, sie kann auch beliebig vergrößerbar ausgebildet sein. Letztlich kann eine Anordnung von weiteren die Funktionsschicht aufweisenden Belagselementen auch nachträglich - das heißt nach der Verlegung der Belagselemente - gewährleistet werden, so dass eine hohe Flexibilität und individuelle Anpassbarkeit sichergestellt werden kann. Zudem können die Belagselemente auch - beispielsweise bei einer Renovierung - wiederverwendet werden, da ein Lösen (eine Demontage) von miteinander verbundenen Belagselementen auf im Stand der Technik bekannter Art und Weise durchgeführt werden kann. Insbesondere wird demzufolge die ökologische Nachhaltigkeit der Belagselemente deutlich verbessert.

Ferner kann die ökologische Komptabilität auch hinsichtlich des Recyclings der Belagselemente verbessert werden. Durch die unterseitige Anordnung der Funktionsschicht an der Trägerplatte kann die Funktionsschicht insbesondere sehr einfach von der Trägerplatte gelöst werden, beispielsweise durch ein Abziehen oder ein Abreißen. Somit kann das restliche bzw. das von der Funktionsschicht befreite Belagselement auf "reguläre" Weise recycelt werden - ohne auf elektrische Komponenten der Funktionsschicht zu achten. Demzufolge ermöglicht eine möglichst einfache Abtrennung der Funktionsschicht ein verbessertes Recycling.

Vorteilhafterweise können an die Funktionsschicht und/oder in der Funktionsschicht elektrische Elemente, die insbesondere eine höhere Aufbauhöhe aufweisen, vorzugsweise über 0,01 mm, insbesondere zwischen 0,1 mm bis 3 mm, weiter bevorzugt zwischen 0,2 mm bis 1 mm, sehr einfach in das Belagselement integrierbar sein. In diesem Zusammenhang kann vorgesehen sein, dass - korrespondierend zu der Ausbildung der elektrischen und/oder elektronischen Elemente - Ausnehmungen unterseitig auf der Trägerplatte vorgesehen sind, die zur Aufnahme der elektrischen und/oder elektronischen Elemente ausgebildet sind. Als elektrische bzw. elektronische Elemente können beispielsweise Prozessoren, Sensoren und/oder Energieversorgungsmittel, beispielsweise Akkumulatoren und/oder Batterien, vorgesehen sein. Die Anordnung derartiger elektrischer Elemente ist bei einer oberseitig vorgesehenen Funktionsschicht, wie sie aus dem Stand der Technik bekannt ist, nur schwer bis gar nicht zu realisieren. Letztlich steht die Aufbauhöhe der elektrischen Elemente einer glatten Nutzseite des Belagselementes entgegen.

Vorzugsweise kann durch die unterseitige Anordnung der Funktionsschicht an der Trägerplatte eine erhöhte Flexibilität im Hinblick auf die Größe der einzelnen Bestandteile der Funktionsschicht ermöglicht werden. Hierdurch steigt die Flexibilität zur Integration von verschiedenen elektrischen Elementen in einem Belagselement, wobei die Auswahl der elektrischen bzw. elektronischen Elemente anhand von individuellen Kundenwünschen durchgeführt werden kann.

Alternativ oder zusätzlich ist es auch möglich, die elektrischen oder elektronischen Elemente innerhalb der Trägerplatte anzuordnen, wobei die elektrischen Elemente mit Energieversorgungsleitungen mit der Funktionsschicht zur Versorgung mit elektrischer Energie verbunden sein können. Letztlich kann durch die Funktionsschicht die Versorgung des Belagselementes mit Energie, vorzugsweise elektrischer Energie, gewährleistet werden.

Bei einer besonders bevorzugten Ausführungsform der vorliegenden Erfindung sind an gegenüberliegenden Seiten der Trägerplatte korrespondierende Nut-Feder-Verbindungsgeometrien vorgesehen. Die Nut-Feder-Verbindungsgeometrien dienen insbesondere zur Ausbildung und zur Verwirklichung einer Klickverbindung. Bei einer Klickverbindung können die miteinander korrespondierenden Seiten ineinander eingeschwenkt bzw. ineinander eingeklickt werden. Die gegenüberliegenden Seiten der Trägerplatte weisen insbesondere eine eine Nut aufweisende Nutseite und eine der Nutseite gegenüberliegende, eine Feder aufweisende Federseite auf. Die Nutseiten und die Federseiten können insbesondere sowohl an den Querseiten als auch an den Längsseiten der Trägerplatte vorgesehen sein. Insbesondere sind an den Seitenrändern der Trägerplatte jeweils zueinander korrespondierende Nut-Feder-Verbindungsgeometrien ausgebildet, insbesondere wobei die gegenüberliegenden Seiten - das heißt die gegenüberliegenden Querseiten und die gegenüberliegenden Längsseiten - korrespondierend zueinander ausgebildet sind. Demzufolge kann die Trägerplatte eine als Nutseite ausgebildete Längs- oder Langseite und eine als Federseite ausgebildete Längs- oder Langseite sowie eine als Nutseite ausgebildete Quer- oder Kurzseite und eine als Federseite ausgebildete Quer- oder Kurzseite aufweisen.

Bei einer weiteren Ausführungsform können neben der Nut-Feder-Verbindung auch andere Verbindungsgeometrien vorgesehen sein. Insbesondere sind an gegenüberliegenden Seiten der Trägerplatte Druckknopf- und/oder Bajonettverbindungsgeometrien vorgesehen.

Demzufolge kann eine den Druckknopf aufweisende Längs- und/oder Querseite und eine zu dem Druckknopf korrespondierende Kupplungsöffnung aufweisende Längs- und/oder Querseite vorgesehen sein. Beim Bajonettverschluss können die Belagselemente untereinander über das Zusammenwirken von wenigstens einem Vorsprung und einer dazu korrespondierenden Öffnung miteinander verbunden werden, insbesondere wobei die Belagselemente über "Ineinanderstecken" und relatives Verschieben zueinander lösbar verbindbar sind.

Alternativ oder zusätzlich kann vorgesehen sein, dass die Funktionsschicht über den Seitenrand der Nutseite, vorzugsweise über den Seitenrand der Nutseite der Längsseite, im Einbauzustand übersteht. Die Anordnung des überstehenden Bereichs der Funktionsschicht an der Nutseite ermöglicht eine verbesserte Verbindung der Funktionsschichten von miteinander zu verbindenden Belagselementen. Durch die Nut und die zumindest mittelbare Anordnung der Funktionsschicht an der Nut kann die Stabilität der Funktionsschicht im überstehenden Bereich gewährleistet werden. Des Weiteren ist vorteilhaft, dass die Nutseite bei Verlegung auf dem Boden bzw. auf dem Untergrund aufliegt und eine zur Nutseite korrespondierende Federseite eines weiteren Belagselementes in die Nutseite eingeschwenkt wird. Dies gilt jedenfalls dann, wenn die Nut-Feder-Verbindungen der einzelnen Belagselemente als Klickverbindungen ausgebildet sind.

Folglich wird durch die Anordnung des überstehenden Bereichs der Funktionsschicht an der Nutseite vermieden, dass der überstehende Bereich der Funktionsschicht eingeschwenkt wird. Insbesondere lassen sich Verlegefehler im Hinblick auf die Anordnung und die Verbindung der Funktionsschicht(en) zumindest im Wesentlichen vermeiden.

Vorzugsweise kann die Funktionsschicht bündig mit dem untersten, äußersten Seitenrand der Trägerplatte abschließen und/oder in diesem Bereich umgeklappt und/oder umgefaltet sein. Insbesondere steht die Funktionsschicht nicht im Bereich der Federseite über.

Alternativ oder zusätzlich ist insbesondere vorgesehen, dass die Funktionsschicht zumindest bereichsweise an dem der Nutseite gegenüberliegenden Bereich der Trägerplatte angeordnet ist, wobei, vorzugsweise, die Anordnung und Ausbildung zum zumindest bereichsweise überstehenden Bereich der Funktionsschicht an der Nutseite korrespondiert. Dies kann im Einbauzustand letztlich insbesondere ermöglichen, dass bei Verbindung des Belagselementes mit einem weiteren Belagselement der überstehende Bereich der Funktionsschicht zumindest bereichsweise kontaktierend und/oder induktiv koppelbar mit wenigstens einem Bereich der Funktionsschicht des weiteren Belagselementes, der unterseitig an der Trägerplatte angeordnet ist, ausgebildet ist.

Darüber hinaus ist bei einer weiteren, besonders bevorzugten Ausführungsform des Erfindungsgedankens vorgesehen, dass die Funktionsschicht in ihrem im Einbauzustand überstehenden Bereich zumindest bereichsweise wenigstens eine Kontaktierungsfläche aufweist, die elektrisch kontaktierend und/oder elektrisch leitend und/oder induktiv koppelbar ausgebildet ist. Die Funktionsschicht kann, wie zuvor erwähnt, auch nur bereichsweise überstehen.

Alternativ oder zusätzlich kann vorgesehen sein, dass die Funktionsschicht auf der der Kontaktierungsfläche gegenüberliegenden Seite eine weitere Kontaktierungsfläche aufweist, die elektrisch kontaktierend und/oder elektrisch leitend und/oder induktiv koppelbar ausgebildet ist. Insbesondere ist die "gegenüberliegende Seite" nicht beschränkend als Ober- und/oder Unterseite der Funktionsschicht zu verstehen. Letztlich ist mit der "gegenüberliegenden Seite" die zumindest im Wesentlichen im Längsrandbereich der Funktionsschicht vorgesehene Seite gemeint, die sowohl oberseitig als auch unterseitig vorgesehen sein kann. Letztlich gibt die vorgenannte Anordnung der weiteren Kontaktierungsfläche vor, dass miteinander zu verbindende Belagselemente über dem überstehenden Bereich der Funktionsschicht, in dem wenigstens eine Kontaktierungsfläche vorgesehen ist, miteinander koppelbar sind. Die weitere Kontaktierungsfläche kann korrespondierend zur Kontaktierungsfläche ausgebildet sein, so dass im Einbauzustand zumindest bereichsweise in wenigstens einem Überlappungsbereich sich die Kontaktierungsfläche und die weitere Kontaktierungsfläche überlappen.

Vorzugsweise ist die weitere Kontaktierungsfläche im zuvor angesprochenen Bereich unterhalb der Trägerplatte angrenzend an die Federseite vorgesehen. Die weitere Kontaktierungsfläche der Funktionsschicht steht - im Einbauzustand - nicht über die Unterseite der Trägerplatte, insbesondere den Längsrand der Längsseite der Federseite, über.

Weiter vorzugsweise sind die Kontaktierungsfläche und die weitere Kontaktierungsfläche derart korrespondierend zueinander ausgebildet, dass die Kontaktierungsfläche des Belagselementes im Einbauzustand mit einer weiteren Kontaktierungsfläche eines weiteren Belagselementes, das mit dem Belagselement verbunden ist, elektrisch leitend verbunden und/oder induktiv gekoppelt ist. Bevorzugt grenzt die Kontaktierungsfläche zumindest bereichsweise unmittelbar an die weitere Kontaktierungsfläche des weiteren Belagselementes im Einbauzustand an, insbesondere wobei eine Anordnung der Kontaktierungsfläche und der weiteren Kontaktierungsfläche zur Verwirklichung des vorgenannten Merkmals ausgebildet ist.

Insbesondere sind die Kontaktierungsfläche und die weitere Kontaktierungsfläche eines weiteren Belagselementes, das mit dem die Kontaktierungsfläche aufweisende Belagselement im Einbauzustand verbunden ist, aufeinander angeordnet und werden durch die Nut-Feder-Verbindungsgeometrien im Einbauzustand letztlich auch zumindest teilweise aufeinander gedrückt bzw. aneinander gehalten, insbesondere wobei die Verbindung der Belagselemente untereinander über die Nut-Feder-Verbindungsgeometrien eine unmittelbare und exakte Anordnung der Kontaktierungsflächen der miteinander verbundenen Belagselemente ermöglicht.

Erfindungsgemäß ist die Funktionsschicht zumindest bereichsweise auf einer Trägerschicht angeordnet. Die Funktionsschicht kann fest mit der Trägerschicht verbunden sein. Vorzugsweise kann vorgesehen sein, dass die Trägerschicht zumindest bereichsweise die Funktionsschicht bildet und/oder dass die Funktionsschicht aus der Trägerschicht besteht. Eine Anordnung der Funktionsschicht auf einer Trägerschicht ermöglicht dabei, dass eine Bereitstellung der Funktionsschicht in dem Schichtaufbau des Belagselementes sehr einfach erfolgen kann. Insbesondere kann die Funktionsschicht gemeinsam mit der Trägerschicht auf eine unterseitige Schicht des Belagselementes, beispielsweise die Trägerplatte, aufkaschiert werden.

Insbesondere kann in einer weiteren Ausführungsform vorgesehen sein, dass die Funktionsschicht wenigstens bereichsweise im Einbauzustand über den Seitenrand des Belagselementes übersteht, jedoch ohne die Trägerschicht. Vorzugsweise kann die Funktionsschicht auf der Trägerschicht angeordnet sein und zumindest bereichsweise ohne die Trägerschicht im Einbauzustand über den Seitenrand des Belagselementes überstehen.

Des Weiteren kann die Trägerschicht durch eine unterhalb der Trägerplatte vorgesehene Schicht und/oder durch die Unterseite der Trägerplatte selbst gebildet werden, insbesondere wobei die Funktionsschicht auf die Trägerschicht aufgedruckt werden kann. Die Trägerschicht kann entsprechend des Herstellungsverfahrens des Belagselementes und/oder der vorgesehenen Verbindung zwischen der Funktionsschicht und der Trägerschicht ausgebildet sein.

Insbesondere kann die Trägerschicht zumindest bereichsweise wenigstens einseitig als Klebeschicht und/oder als Klebstoff aufweisende Trägerschicht ausgebildet sein. Demgemäß kann die Trägerschicht sehr einfach an das Belagselement, insbesondere die Unterseite der Trägerplatte, angeordnet werden.

Zudem kann vorgesehen sein, dass die Trägerschicht elastisch und/oder flexibel ausgebildet ist. Dies ermöglicht eine platzsparende Lagerung der Trägerschicht und ebenfalls eine vereinfachte Anordnung der mit der Funktionsschicht versehenen Trägerschicht an das Belagselement.

Erfindungsgemäß ist es möglich, dass die Trägerschicht einseitig und/oder beidseitig zumindest bereichsweise die bzw. eine Funktionsschicht aufweist. Die Anordnung der Kontaktierungsfläche kann sowohl bei der einseitigen als auch bei der beidseitigen Bedruckung an der der Trägerplatte zugewandten Oberseite der Trägerschicht vorgesehen sein.

Bei einer weiteren bevorzugten Ausführungsform ist vorgesehen, dass die weitere Kontaktierungsfläche an der der Trägerplatte abgewandten Seite der Trägerschicht, insbesondere an der Unterseite der Trägerschicht, angeordnet ist. Eine derartige Anordnung der weiteren Kontaktierungsfläche ist insbesondere bei einer beidseitigen Anordnung der Funktionsschicht auf der Trägerschicht vorgesehen. Eine beidseitige Anordnung der Funktionsschicht auf der Trägerschicht ermöglicht insbesondere, dass die Trägerschicht bündig und/oder zumindest im Wesentlichen unmittelbar angrenzend an die Federseite der Trägerplatte angeordnet und eine somit herstellbare Verbindung der Kontaktierungsfläche mit der weiteren Kontaktierungsfläche von wenigstens zwei miteinander verbundenen Belagselementen sichergestellt werden kann. Bevorzugt ist es jedenfalls so, dass die Trägerschicht und damit auch die Funktionsschicht nicht über die Federseite der Trägerplatte übersteht.

Vorzugsweise ist bei einer weiteren Ausführungsform vorgesehen, dass die Trägerschicht und/oder die Funktionsschicht federseitig, insbesondere im Bereich der Federseite der Trägerplatte, zumindest abschnittsweise eingefaltet und/oder umgeklappt ist. Die weitere Kontaktierungsfläche kann auf dem der Trägerplatte abgewandten, eingeklappten und/oder umgefalteten Bereich der Trägerschicht und/oder der Funktionsschicht vorgesehen sein. Vorteilhaft an dem eingeklappten und/oder umgeklappten Bereich der Trägerschicht und/oder der Funktionsschicht ist, dass die Funktionsschicht nicht beidseitig auf der Trägerschicht angeordnet sein muss.

Ein Einklappen und/oder Umklappen der Trägerschicht ermöglicht dabei zudem, dass im Einbauzustand der eingeklappte und/oder umgeklappte Bereich zumindest bereichsweise überlappend mit dem überstehenden Bereich der Funktionsschicht bzw. der Trägerschicht angeordnet ist. Somit kann eine Kontaktierung der Kontaktierungsfläche und der weiteren Kontaktierungsfläche auch bei einer wenigstens einseitigen Anordnung der Funktionsschicht auf der Trägerschicht ermöglicht werden.

Außerdem ergeben sich weitere Vorteile durch den eingeklappten und/oder umgefalteten Bereich der Trägerschicht. So kann durch die Faltung bzw. durch eine entsprechende Falzung erreicht werden, dass eine Rückstellkraft zusätzlich zur Gravitationskraft auftritt, die im Einbauzustand den eingeklappten und/oder umgefalteten Bereich der Trägerschicht, der die weitere Kontaktierungsfläche zumindest bereichsweise aufweist, an den überstehenden Bereich der Trägerschicht, der die Kontaktierungsfläche aufweist, drückt.

In diesem Zusammenhang ist vorteilhaft, wenn die Faltung im "Knick" des eingeklappten und/oder umgefalteten Bereich einen Winkel von weniger als 180° vorsieht, insbesondere zwischen 90° bis 179°, bevorzugt von 100° bis 170°. Eine Anordnung des eingeklappten und/oder umgefalteten Bereich auf den überstehenden Bereich der Trägerschicht auf der Nutseite ermöglicht insbesondere durch den vorhandenen Anpressdruck eine bessere elektrische Kontaktierung und/oder eine verbesserte induktive Kopplung.

Bei einer weiteren bevorzugten Ausführungsform ist vorgesehen, dass die Funktionsschicht, vorzugsweise federseitig, zumindest abschnittsweise nach unten - d.h. insbesondere der Trägerschicht abgewandt - umgeklappt und/oder eingefaltet ist, insbesondere so dass die Kontaktierung zwischen der Funktionsschicht des Belagselementes zu der weiteren Funktionsschicht eines weiteren Belagselementes unterhalb der Trägerschichten - insbesondere nicht zwischen den Verbindungsgeometrien - des Belagselementes und des weiteren Belagselementes vorgesehen ist. Vorzugsweise reicht die Funktionsschicht des Belagselementes nicht in den Bereich der Verbindungsgeometrien hinein bzw. ist in diesem Bereich angeordnet. Insbesondere kann vorgesehen sein, dass die Funktionsschicht unterhalb der Verbindungsgeometrie - d.h. der Trägerschicht abgewandt - angeordnet ist.

Wie zuvor erläutert, ist besonders vorteilhaft, dass die Funktionsschicht auf der Trägerschicht einseitig, vorzugsweise auf der der Trägerplatte zugewandten Oberseite der Trägerschicht, und/oder beidseitig vorgesehen ist. Insbesondere ist bei einer beidseitigen Anordnung der Funktionsschicht auf der Trägerschicht vorgesehen, dass die Funktionsschicht der Oberseite der Trägerschicht mit der Funktionsschicht der Unterseite der Trägerschicht mittels wenigstens eines Verbindungsmittels elektrisch leitend und/oder induktiv koppelbar verbunden ist. Als Verbindungsmittel können beispielsweise Nieten und/oder Krampen, die jeweils elektrisch leitend sind, vorgesehen sein. Letztlich wird insbesondere das Verbindungsmittel an derjenigen Stelle der Trägerschicht angeordnet, an der die Verbindung der Funktionsschichten ermöglicht werden soll. Dabei versteht es sich letztlich, dass auch mehr als ein Verbindungsmittel vorgesehen sein kann, insbesondere für eine Mehrzahl von Funktionsschichten und/oder für Funktionsschichten aufweisende Bereiche.

Das Material der Trägerschicht kann entsprechend der Funktionsschicht, des Materials der weiteren, vorzugsweise unmittelbar mit der Trägerschicht verbundenen, Schichten des Belagselementes und/oder der elektrischen Funktionalität der Funktionsschicht ausgewählt sein. Insbesondere kann vorgesehen sein, dass die Trägerschicht zumindest bereichsweise ein elektrisch leitendes und/oder ein elektrisch isolierendes Material aufweist.

Als elektrisch isolierendes Material kann, insbesondere für eine dünne Trägerschicht, ein Kunststoffmaterial, Holz, Papier, Karton, Kork und/oder Filz und/oder Glas vorgesehen sein. Besonders bevorzugt weist die Trägerschicht als Material Polypropylen (PP), Polyethylen (PE), Polyvinylchlorid (PVC) und/oder Polyethylenterephthalat (PET) auf.

Als elektrisch leitendes Material kann für die Trägerschicht insbesondere ein metallisches und/oder ein wenigstens ein Metall aufweisendes Material vorgesehen sein. Besonders bevorzugt weist die Trägerschicht als Material Aluminium, Kupfer, Silber und/oder Gold auf und/oder besteht daraus. Die vorgenannten Materialien einer elektrisch leitenden Trägerschicht können zumindest bereichsweise eine gute elektrische Leitfähigkeit der Trägerschicht ermöglichen.

Ein elektrisch isolierendes Material der Trägerschicht zeichnet sich dadurch aus, dass durch die Trägerschicht die Funktionsschicht letztlich nicht beeinflusst wird und/oder dass die Funktionsschicht zudem auch zumindest bereichsweise gegen die weiteren Schichten des Belagselementes isoliert werden kann. Vorteilhaft an einer elektrisch leitenden Trägerschicht ist jedoch wiederum, dass die Trägerschicht zumindest bereichsweise selbst die Funktionsschicht bildet. Somit kann eine zusätzliche Aufkaschierung und/oder ein Aufdrucken der Funktionsschicht auf der Trägerschicht vermieden werden. Dies vereinfacht insbesondere die Herstellung der Funktionsschicht und/oder der Trägerschicht.

Bei einer weiteren, ganz besonders bevorzugten Ausführungsform ist vorgesehen, dass auf der Trägerschicht wenigstens eine Messeinrichtung der Funktionsschicht angeordnet ist. Vorzugsweise ist die Messeinrichtung auf die Trägerschicht aufgedruckt. Als Messeinrichtung kann beispielsweise wenigstens ein Sensor, vorzugsweise ein Drucksensor und/oder ein kapazitiver Sensor, vorgesehen sein.

Vorzugsweise ist die Messeinrichtung fest mit der Trägerschicht verbunden. Zudem kann die Messeinrichtung zur Erfassung der auf das Belagselement wirkenden Druckänderung und/oder Kapazitätsänderung ausgebildet sein. Eine Ermittlung der Druckänderung, insbesondere des auf die Nutzseite des Belagselementes einwirkenden Druckes, wird durch die Messeinrichtung, die unterseitig an der Trägerplatte angeordnet ist, gemessen bzw. erfasst.

Beim Zustandekommen der Erfindung hat sich überraschenderweise gezeigt, dass durch die unterseitige Anordnung der Funktionsschicht die Druckmessung letztlich im Vergleich zu einer oberhalb der Trägerplatte vorgesehenen Anordnung der Messeinrichtung nur unwesentlich verändert bzw. beeinflusst wird, so dass die auf das Belagselement wirkende Druckänderung insbesondere mit einer Abweichung von maximal +/- 15 % ermittelt werden kann.

Als kapazitiver Sensor ist insbesondere ein Sensor zu verstehen, der auf Basis der Veränderung der elektrischen Kapazität (z. B. eines einzelnen Kondensators oder eines Kondensatorsystems) arbeitet. Letztlich misst und/oder erfasst der kapazitive Sensor eine Kapazitätsänderung. Eine Kapazitätsänderung kann insbesondere durch eine Veränderung eines Objektes (beispielsweise eine Person) oberseitig des Belagselementes im Raum (räumliche Veränderung) erfolgen.

Alternativ oder zusätzlich kann vorgesehen sein, dass als Sensor ein kapazitiver Drucksensor verwendet wird.

Darüber hinaus kann ferner als kapazitiver Sensor ein Abstandssensor und/oder Näherungsschalter verwendet werden.

Insbesondere kann der kapazitive Sensor derart ausgebildet sein, dass beispielsweise die aktive Sensorfläche des Sensors die Annäherung einer Person und/oder eines Objektes detektiert.

Insbesondere ist als Drucksensor ein Sensor zu verstehen, der eine Druckdifferenz, einen stationären Druck und/oder Druckschwankungen misst. Erfindungsgemäß sind unterschiedliche Ausbildungen des Drucksensors möglich.

Ferner kann der Drucksensor derart ausgebildet sein, dass er das Ausbleiben einer Druckänderung eines auf das Belagselement wirkenden Druckes erfasst.

Eine Erfassung der auf das Belagselement wirkenden Druckänderung zeigt sich beispielsweise bei der Verwendung des Belagselements zur Bildung eines Bodenbelages als vorteilhaft. So kann erfindungsgemäß erkannt werden, ob eine Person einen mit der Funktionsschicht ausgestatteten Bereich eines Belages betritt und/oder gefallen ist.

Das gleiche Prinzip (Druckmessung) ist auch beim Betreten des Belagselementes anwendbar, so dass beispielsweise der mit der Funktionsschicht ausgestattete Bereich des Belages in Kombination mit einer Alarmanlage genutzt werden kann. Bei "Scharfstellung" bzw. Aktivierung kann ein Betreten des Bodenbelages, insbesondere einer Person, zu einem Auslösen eines Alarms führen.

Jedoch ist auch das Registrieren einer gestürzten Person vorteilhaft, insbesondere für morbide und/oder kranke und/oder schwache Menschen, deren Gesundheitszustand überwacht werden sollte. So können gestürzte Menschen zeitnah Hilfe erhalten, insbesondere ohne selbst einen Alarm auslösen zu müssen. Gesundheitliche Langzeitschäden können insbesondere hierdurch reduziert werden.

Vorzugsweise kann die Messeinrichtung alternativ oder zusätzlich zur Ermittlung der Temperatur und/oder der Feuchtigkeit ausgebildet sein. Insbesondere kann eine Überwachung der Bausubstanz in schwer zugänglichen Bereichen erfolgen, wie beispielsweise unter einem Bodenbelag.

Sofern die Funktionsschicht, insbesondere die Messeinrichtung, wenigstens einen kapazitiven Sensor aufweist, so kann vorgesehen sein, dass der kapazitive Sensor der Messeinrichtung sich zumindest im Wesentlichen vollflächig über die Trägerschicht und/oder über die Funktionsschicht erstreckt. Insbesondere weist die Kontaktierungsfläche und/oder die weitere Kontaktierungsfläche zumindest im Wesentlichen vollflächig den kapazitiven Sensor auf.

Vorzugsweise erstreckt sich der kapazitive Sensor teilflächig oder vollflächig über die Unterseite der Trägerplatte - sowohl bei einer mittelbaren als auch bei einer unmittelbaren Verbindung mit der Trägerplatte.

Bei der Verwendung eines kapazitiven Sensors zur Erfassung der Kapazitätsänderung ist insbesondere eine elektrische Kopplung von miteinander zu verbindenden Belagselementen vorgesehen.

Erfindungsgemäß sind wenigstens zwei Leiterbahnen der Funktionsschicht an der Trägerschicht angeordnet. Insbesondere sind die Leiterbahnen auf die Trägerschicht aufgedruckt worden. Die Trägerschicht kann die Leiterbahnen bereichsweise und/oder auf der der Unterseite der Trägerplatte zugewandten Oberseite der Trägerschicht oder zusätzlich auch auf der der Trägerplatte abgewandten Unterseite der Trägerschicht aufweisen.

Sofern die Trägerschicht zumindest bereichsweise beidseitig die Leiterbahnen aufweist, so kann vorgesehen sein, dass die mit den Leiterbahnen zumindest bereichsweise versehene Unterseite der Trägerschicht zumindest bereichsweise die weitere Kontaktierungsfläche bildet und/oder aufweist.

Eine einseitige Anordnung der Leiterbahnen auf der Trägerschicht kann insbesondere in Kombination mit dem eingeklappten und/oder umgefalteten Bereich der Trägerschicht umgesetzt sein. Hierbei kann der zumindest abschnittsweise die weitere Kontaktierungsfläche aufweisende Bereich umgeklappt sein, insbesondere wobei die weitere Kontaktierungsfläche zumindest bereichsweise die Leiterbahnen aufweisen kann. Insbesondere sind die Leiterbahnen zur Energieversorgung der Messeinrichtung, vorzugsweise des Drucksensors, vorteilhaft und/oder vorgesehen. Über die in dem Kontaktierungsbereich und in dem weiteren Kontaktierungsbereich angeordneten Leitungen bzw. Leiterbahnen kann elektrische Energie zwischen bzw. unter miteinander verbundenen Belagselementen weitergeleitet werden.

Letztlich kann die elektrische Kontaktierung der miteinander zu verbindenden Belagselemente über die Kontaktierungsfläche, die weitere Kontaktierungsfläche und die in den jeweiligen Kontaktierungsflächen vorgesehenen Leiterbahnen erfolgen. Hierfür ist insbesondere vorgesehen, dass die Leiterbahnen der Kontaktierungsfläche sich zumindest bereichsweise mit den dazu korrespondierenden Leiterbahnen der weiteren Kontaktierungsfläche im Einbauzustand von miteinander verbundenen Belagselementen überschneiden bzw. überlappen.

Bei der Verwendung eines zumindest im Wesentlichen vollflächig über der Trägerschicht angeordneten kapazitiven Sensors kann die Verwendung von Leiterbahnen vermieden werden.

Darüber hinaus können die Leiterbahnen auch zur Versorgung weiterer elektrischer Elemente der Funktionsschicht genutzt werden.

Vorzugsweise sind die Leiterbahnen zumindest bereichsweise elektrisch isoliert. Insbesondere sind die Leiterbahnen in wenigstens einer Kontaktierungsfläche und/oder wenigstens einer weiteren Kontaktierungsfläche zumindest bereichsweise elektrisch isoliert. Eine Isolierung kann insbesondere durch einen isolierenden Schutzlack erfolgen, der auf die zu isolierenden Bereiche der Leiterbahnen und gegebenenfalls zusätzlich auch bereichsweise auf die Trägerschicht aufgebracht werden kann. Durch die Verwendung eines elektrisch isolierenden Materials auf den Leiterbahnen kann bei Überlappung der Kontaktierungsfläche mit der weiteren Kontaktierungsfläche, in denen jeweils die Leiterbahnen vorgesehen sind, insbesondere ein Kurzschluss vermieden werden. Dieser könnte dann auftreten, wenn eine Leiterbahn wenigstens zwei Leiterbahnen der dazu korrespondierenden Kontaktierungsfläche und/oder weiteren Kontaktierungsfläche schneiden bzw. kontaktieren würde.

Insbesondere kann der elektrisch isolierende Lack und/oder das elektrisch isolierende Material auf diejenigen Bereiche der Leiterbahnen und/oder der Funktionsschicht(en) aufgebracht werden, die - auch bei Verschiebung der Belagselemente gegeneinander (zumindest in gewissen Bereichen) - eine elektrische Kontaktierung von nicht zueinander korrespondierenden Leiterbahnen ermöglichen würden. Es kann vorgesehen sein, dass jeweils zwei Leiterbahnen der Kontaktierungsfläche und der weiteren Kontaktierungsfläche miteinander verbunden werden.

Bei einer weiteren ganz besonders bevorzugten Ausführungsform der Erfindung ist vorgesehen, dass die Leiterbahnen derart in wenigstens einer Kontaktierungsfläche und/oder in wenigstens einer weiteren Kontaktierungsfläche angeordnet sind, dass sie im Einbauzustand des Belagselementes mit den jeweiligen Leiterbahnen eines mit dem Belagselement verbundenen weiteren Belagselementes elektrisch leitend verbunden und/oder induktiv gekoppelt sind. Die Leiterbahnen des Belagselementes können mit den Leiterbahnen des weiteren Belagselementes überlappend angeordnet sein. Bei einer überlappenden Anordnung der Leiterbahnen ist insbesondere eine zumindest bereichsweise elektrische Isolierung wenigstens einer Leiterbahn vorgesehen.

Ferner weist insbesondere wenigstens eine Leiterbahn, vorzugsweise wenigstens zwei Leiterbahnen, in der Kontaktierungsfläche und/oder in der weiteren Kontaktierungsfläche eine winklige Anordnung bzw. Ausbildung auf und/oder die Leiterbahnen sind abgewinkelt in die Kontaktierungsfläche und/oder die weitere Kontaktierungsfläche geführt worden. Die Leiterbahnen können im Bereich der Kontaktierungsfläche und/oder der weiteren Kontaktierungsfläche einen zumindest im Wesentlichen geradlinig verlaufenden Abschnitt aufweisen, insbesondere wobei die wenigstens zwei Leiterbahnen der Kontaktierungsfläche und/oder der weiteren Kontaktierungsfläche zumindest im Wesentlichen parallel zueinander angeordnet sein können. Auch weitere bzw. andere geometrische Anordnungen der Leiterbahnen im Bereich der Kontaktierungsfläche und/oder der weiteren Kontaktierungsfläche können erfindungsgemäß vorgesehen sein. Insbesondere ist die Ausbildung der Leiterbahnen der weiteren Kontaktierungsfläche hinsichtlich der geometrischen Ausbildung der Leiterbahnen der Kontaktierungsfläche korrespondierend, symmetrisch und/oder spiegelverkehrt - im Einbauzustand - ausgebildet.

Bei einer weiteren bevorzugten Ausführungsform ist vorgesehen, dass in wenigstens einer Kontaktierungsfläche und/oder in einer weiteren Kontaktierungsfläche wenigstens zwei Paare von wenigstens jeweils zwei Leiterbahnen vorgesehen sind. Diese Paare können in einer Kontaktierungsfläche, die sich insbesondere über zumindest im Wesentlichen die gesamte Längsnutseite der Trägerplatte erstreckt, vorgesehen sein. Zudem kann auch insbesondere jeweils ein Paar in einer Kontaktierungsfläche angeordnet sein. Korrespondierend kann die Anordnung der Paare der Leiterbahnen im Bereich der weiteren Kontaktierungsfläche vorgesehen sein.

In diesem Zusammenhang kann vorgesehen sein, dass sich die Leiterbahnen in ihrem zumindest im Wesentlichen geraden, geradlinigen und/oder zumindest im Wesentlichen linienförmigen Verlauf über circa 3 bis 50 %, bevorzugt von 5 bis 25 %, weiter bevorzugt von 7 bis 15 %, der Länge der Längsseite der Trägerplatte im Bereich des überstehenden Bereichs der Trägerschicht bzw. der Funktionsschicht erstrecken. Dies ermöglicht insbesondere, dass die weiteren Belagselemente entlang der Nutlängsseite der Trägerplatte bzw. des Belagselementes bedarfsweise verschoben werden können, ohne dass die Kontaktierung durch das Verschieben unterbrochen wird. Dem Nutzer können durch Verlegevorgaben die möglichen längsverschieblichen Bereiche an der Nutseite der Trägerplatte bzw. des Belagselementes vorgegeben werden.

Des Weiteren kann bei einer weiteren Ausführungsform des Erfindungsgedankens vorgesehen sein, dass wenigstens eine Leiterbahn im Bereich der Kontaktierungsfläche und/oder der weiteren Kontaktierungsfläche eine größere Breite als die dazu korrespondierende Leiterbahn der weiteren Kontaktierungsfläche aufweist. Letztlich kann erfindungsgemäß vorgesehen sein, dass die Leiterbahnen der Kontaktierungsfläche und/oder der weiteren Kontaktierungsfläche sich hinsichtlich ihrer Breite unterscheiden. Die Leiterbahnen der Kontaktierungsfläche können eine um 10 % bis 500 %, bevorzugt von 20 % bis 100 %, weiter bevorzugt von 20 % bis 70 %, größere Breite als die dazu korrespondierenden Leiterbahnen der weiteren Kontaktierungsfläche aufweisen oder vice versa.

Insbesondere ist es erfindungsgemäß auch möglich, dass lediglich einzelne Bereiche bzw. Abschnitte der Leiterbahnen die größere Breite aufweisen. In diesem Zusammenhang versteht es sich, dass sowohl die Leiterbahnen der weiteren Kontaktierungsfläche als auch die der Kontaktierungsfläche als "bereitere" Leiterbahnen ausgebildet sein können.

Eine unterschiedliche Breite der Leiterbahnen ist dahingehend vorteilhaft, da bei Anordnung des weiteren Belagselementes an das Belagselement ein gewisser "Spielraum" bei der Verlegung geschaffen wird. Es kann stets eine hinreichende elektrische Kontaktierung der Leiterbahnen des Belagselementes und des weiteren Belagselementes ermöglicht werden, insbesondere auch bei Vorhandensein eines Spalts zwischen der Federseite des weiteren Belagselements und der Nutseite des Belagselementes.

Des Weiteren sind breitere Leiterbahnen auch dahingehend vorteilhaft, dass sie im Einbauzustand die Kontaktierung durch Überlappung jedenfalls auch dann sicherstellen, wenn sich die Belagselemente, und insbesondere die auch damit verbundenen Funktionsschichten der Belagselemente, bewegen, insbesondere - beispielsweise - durch Schwindung, oder sich fertigungsbedingt Abweichungen ergeben.

Durch unterschiedliche Breiten der Leiterbahnen können damit verlegungsbedingte Überscheidungstoleranzen ausgeglichen werden.

Die Breite und/oder die Ausgestaltung einer Leiterbahn kann in Abhängigkeit der auftretenden bzw. zu übertragenden elektrischen Spannung im Einbauzustand ausgebildet sein.

Alternativ oder zusätzlich zu einer unterschiedlichen Breite der Leiterbahnen kann - zur Verbesserung der Verlegefreundlichkeit - der Abstand zwischen den Leiterbahnen eines Leiterbahn-Paares variiert, insbesondere vergrößert, werden.

Besonders bevorzugt ist der Funktionsschicht und/oder der Messeinrichtung eine Verarbeitungseinrichtung zugeordnet. Insbesondere ist die Verarbeitungseinrichtung in der Funktionsschicht vorgesehen und/oder als Teil der Funktionsschicht ausgebildet, wobei sie auf der Trägerschicht angeordnet sein kann. Die Verarbeitungseinrichtung kann zur Verarbeitung der von der Messeinrichtung aufgenommenen Informationen ausgebildet sein. Grundsätzlich ist es erfindungsgemäß auch möglich, dass die Verarbeitungseinrichtung nicht unmittelbar an der Trägerschicht angeordnet ist. Sie kann beispielsweise extern von dem Belagselement vorgesehen sein.

Bei einer weiteren bevorzugten Ausführungsform der Erfindung ist vorgesehen, dass die Messeinrichtung und/oder die Verarbeitungseinrichtung mit wenigstens einer Informationsübertragungsleitung zur Übertragung der durch die Messeinrichtung aufgenommenen, insbesondere durch die Verarbeitungseinrichtung verarbeiteten, Informationen verbunden ist. Die Informationsübertragungsleitung kann als Leiterbahn und/oder als Bestandteil der Funktionsschicht vorgesehen bzw. ausgebildet sein.

Insbesondere kann eine Informationsübertragungsschnittstelle in wenigstens einem Kontaktierungsbereich angeordnet sein, wobei die Informationsübertragungsschnittstelle mit wenigstens einer Informationsübertragungsleitung verbunden ist. Als Kontaktierungsbereich kann die Kontaktierungsfläche und/oder die weitere Kontaktierungsfläche der Funktionsschicht vorgesehen sein.

Grundsätzlich kann die Informationsübertragung auch über die elektrischen Leiterbahnen erfolgen, insbesondere sind die Informationsübertragungsschnittstellen nicht zwingend zur Informationsübertragung notwendig.

Über die Informationsübertragungsschnittstelle können Informationen an ein weiteres Belagselement übertragbar sein, insbesondere an eine dazu korrespondierende Informationsübertragungsschnittstelle des weiteren Belagselementes. Die Informationsübertragungsschnittstelle kann besonders bevorzugt im Bereich der Kontaktierungsfläche und/oder der weiteren Kontaktierungsfläche angeordnet sein.

Alternativ oder zusätzlich ist vorgesehen, dass die Informationsübertragungsschnittstelle zur kabellosen Informationsübertragung, insbesondere per Funk, ausgebildet ist, vorzugsweise über eine Antenne.

Vorteilhafterweise ist im Einbauzustand vorgesehen, dass die jeweiligen Informationsübertragungsschnittstellen von - zumindest bereichsweise - miteinander verbundenen Belagselementen überlappend angeordnet sind.

Vorzugsweise kann die Messeinrichtung, die Informationsübertragungsleitung und/oder die Verarbeitungseinrichtung mit wenigstens einer Übertragungseinrichtung verbunden sein. Insbesondere kann die Übertragungseinrichtung als Antenne ausgebildet sein, so dass die Informationen per Funk übertragbar sind.

Die Übertragungseinrichtung kann alternativ oder zusätzlich zur, vorzugsweise kabellosen, Übertragung von Informationen an eine, vorzugsweise externe, Auswerteeinrichtung ausgebildet sein. Die Auswerteeinrichtung kann insbesondere die gemessenen Informationen, die vorzugsweise bereits durch die Verarbeitungseinrichtung verarbeitet worden sind, auswerten. Die Auswerteeinrichtung kann erkennen, ob ein Signal zur Alarmierung bzw. Signalgebung oder dergleichen genutzt werden soll. Ein Signal könnte jedenfalls dann ausgelöst werden, wenn das Belagselement, gegebenenfalls für einen längeren Zeitraum, einem Druck ausgesetzt ist, beispielsweise durch eine Person, die auf dem Belagselement steht und/oder liegt.

Darüber hinaus kann wenigstens ein Drucksensor der Messeinrichtung mit wenigstens zwei Leiterbahnen elektrisch verbunden sein, insbesondere wobei die elektrischen Leitungen (Leiterbahnen) mehrpolig und/oder verschiedenpolig ausgebildet sind.

Insbesondere ist vorgesehen, dass die Funktionsschicht eine gedruckte Schaltung aufweist und/oder daraus besteht.

Vorzugsweise kann die Funktionsschicht unmittelbar auf die Trägerschicht aufgedruckt worden sein. Bei einer Herstellung durch ein Druckverfahren ergibt sich unter anderem der Vorteil, dass die Funktionsschicht direkt bei ihrer Herstellung mit der Trägerschicht fest verbunden werden kann. Zudem kann auch die Funktionsschicht zumindest im Wesentlichen individuell oder zweckgerichtet auf das jeweilige Belagselement abgestimmt werden. Darüber hinaus ergibt sich durch ein Drucken der Funktionsschicht und/oder durch ein zumindest teilweises (bereichsweise) vorgesehenes Drucken der Funktionsschicht eine einfache Möglichkeit der Verbindung sowie der Herstellung der Funktionsschicht. Die Funktionsschicht kann mittels des Digitaldruckes, des Siebdruckes und/oder des Rollenoffsetdruckes druckbar ausgebildet sein. Darüber hinaus kann sie mittels eines, insbesondere durch Drucken aufbringbares, leitfähiges Material gedruckt worden sein. Beispielsweise kann eine Silberpigmente aufweisende Tinte vorgesehen sein. Das Material der Funktionsschicht wird in Abhängigkeit der elektrischen Funktionalität der Funktionsschicht, der auftretenden Spannung und/oder in Abhängigkeit des Druckvorganges ausgewählt.

Bei einer weiteren Ausführungsform des Erfindungsgedankens ist vorgesehen, dass die Trägerschicht mit ihrer der Trägerplatte zugewandten Oberseite als separate Schicht zur Verbindung mit einer weiteren Schicht des Belagselementes, insbesondere der Trägerplatte, ausgebildet ist. Vorzugsweise ist auch an der der Trägerplatte zugewandten Oberseite der Trägerschicht die Funktionsschicht angeordnet. Die Trägerschicht muss dabei nicht vollflächig zur Verbindung ausgebildet sein. Insbesondere können auch lediglich Teilbereiche der Trägerschicht zur Verbindung dienen. Insbesondere kann vorgesehen sein, dass die Oberseite der Trägerschicht und/oder die Unterseite der Trägerschicht zumindest bereichsweise als Klebefolie ausgebildet ist. Durch die Ausbildung als Klebefolie ergibt sich eine vereinfachte Anordnung der Trägerschicht an weitere Schichten des Belagselementes, insbesondere an die Trägerplatte.

Bei der Ausbildung des Belagselementes ist vorzugsweise vorgesehen, dass an der Oberseite der Trägerplatte wenigstens ein, vorzugsweise mehrlagiger, Schichtaufbau angeordnet ist. Der Schichtaufbau kann fest mit der Trägerplatte verbunden sein. Dabei kann der Schichtaufbau zudem zum Schutz der Trägerplatte ausgebildet sein, wobei die Oberseite des Schichtaufbaus die Nutzseite des Belagselementes bilden kann. Der obere Schichtaufbau ist demgemäß den Beanspruchungen des Belagselementes ausgesetzt. Vorteilhaft ist in diesem Zusammenhang, wenn der Schichtaufbau wenigstens eine Verschleißschicht aufweist, die zumindest im Wesentlichen der Nutzseite zugewandt ist und zudem auch verschleißresistente Partikel, insbesondere Korund, aufweist und/oder als Material Kunststoff aufweist und/oder daraus besteht, insbesondere Polyethylen (PE), Polypropylen (PP), Polyvinylchlorid (PVC) und/oder Polyethylenterephthalat (PET).

Bei einer weiteren bevorzugten Ausführungsform ist vorgesehen, dass der Schichtaufbau wenigstens eine Dekorschicht, insbesondere eine Dekorfolie, aufweist. In diesem Zusammenhang kann vorgesehen sein, dass das Belagselement letztlich als Laminat verwendet werden kann. Auch eine Verwendung des Belagselementes als Parkett kann vorgesehen sein. Bei dieser Ausführungsform kann der Schichtaufbau wenigstens eine Echtholzdeckschicht aufweisen.

Darüber hinaus kann der Schichtaufbau auch eine Deckschicht, die insbesondere die Verschleißschicht aufweist, beinhalten. Die Deckschicht, insbesondere ein Overlay, kann zur Versiegelung der Dekorschicht dienen. Alternativ oder zusätzlich kann vorgesehen sein, dass eine Echtholzdeckschicht durch eine Schutzschicht und/oder Versiegelung, die oberseitig auf die Echtholzdeckschicht aufbringbar ist, geschützt werden kann. Der mehrlagige Schichtaufbau und/oder die Lagen des mehrlagigen Schichtaufbaus können insbesondere auf die Trägerplatte aufkaschiert werden. Alternativ oder zusätzlich kann vorgesehen sein, dass der Schichtaufbau mit der Trägerplatte verpresst ist.

Bei einer weiteren, ganz besonders bevorzugten Ausführungsform des Erfindungsgedankens ist vorgesehen, dass der Unterseite der Trägerplatte zugewandt ein Gegenzug angeordnet ist. Insbesondere kann der Gegenzug zur Aufnahme von Biegebeanspruchungen und/oder zum Ausgleich der Biegebeanspruchungen des Belagselementes, insbesondere der Trägerplatte, dienen. Als Gegenzug kann ein Kraftpapier vorgesehen sein. Alternativ oder zusätzlich ist es möglich, dass die Funktionsschicht zwischen dem Gegenzug und der Trägerplatte, vorzugsweise unmittelbar angeordnet an die Trägerplatte, und/oder unterhalb des Gegenzugs angeordnet ist. Des Weiteren kann vorgesehen sein, dass die Trägerschicht und/oder die Funktionsschicht durch den Gegenzug gebildet wird. Dies bedeutet letztlich, dass die Trägerschicht dann eine Doppelfunktion ausübt, nämlich zum einen die Funktion des Gegenzugs und zum anderen die Basis für die Funktionsschicht.

Ferner kann in dem Schichtaufbau des Belagselementes eine Dämpfungsschicht, insbesondere zur Trittschalldämmung, angeordnet sein. Die Dämpfungsschicht kann der Unterseite der Trägerplatte zugewandt sein. Insbesondere kann sie unmittelbar an den Gegenzug angrenzen. Die Dämpfungsschicht kann eine Kunststoff aufweisende Folienschicht und/oder eine Schaumstoff aufweisende Schicht sein, insbesondere wobei die Dämpfungsschicht als Trägerschicht bzw. die Trägerschicht als Dämpfungsschicht ausgebildet ist und/oder wobei die Funktionsschicht und/oder die Trägerschicht fest, vorzugsweise unmittelbar, mit der Dämpfungsschicht verbunden ist. Die Dämpfungsschicht kann darüber hinaus auch zum Ausgleich von Unebenheiten des Untergrundes vorgesehen sein. Letztlich ermöglicht die Dämpfungsschicht eine verbesserte Anordnung bzw. Anpassung des Belagselementes an den Untergrund.

Vorzugsweise kann als Trägerplatte eine HDF-Platte (Hochdichte Faserplatte), eine Echtholzschicht und/oder eine MDF-Platte (Mitteldichte Holzfaserplatte) vorgesehen sein. Die vorgenannten Trägerplatten zeichnen sich durch eine hohe Steifigkeit in Verbindung mit einer hohen Stabilität aus, die sie für das gesamte Belagselement bereitstellen können.

Des Weiteren kann als Material für die Trägerplatte Polyvinylchlorid (PVC), Kork und/oder Mineralstoffe vorgesehen sein.

Bei einer weiteren ganz besonders bevorzugten Ausführungsform ist vorgesehen, dass der Funktionsschicht eine Negativmaskenschicht zum Ausgleich von überstehenden Konturen zugeordnet ist. Durch die Negativmaskenschicht kann insbesondere die Funktionsschicht vor Beanspruchungen, insbesondere durch unterschiedliche Höhen der Funktionsschicht, geschützt werden, insbesondere bei Belastung des Belagselementes.

Gemäß einer weiteren ganz besonders bevorzugten Ausführungsform des Erfindungsgedankens ist vorgesehen, dass die Funktionsschicht zumindest bereichsweise, vorzugsweise vollständig, durch einen elektrisch positiv oder negativ geladenen Bereich gebildet wird, insbesondere wenn die Messeinrichtung einen kapazitiven Sensor aufweist.

Alternativ oder zusätzlich kann vorgesehen sein, dass die Funktionsschicht, insbesondere die als kapazitiver Sensor ausgebildete Funktionsschicht, mehrteilig ausgebildet ist, insbesondere wobei die Teile (Bereiche und/oder Schichten) der Funktionsschicht voneinander elektrisch getrennt bzw. isoliert sind. Insbesondere kann wenigstens ein elektrisch positiv geladener Bereich und wenigstens ein elektrisch negativ geladener Bereich der Funktionsschicht vorgesehen sein.

Vorzugsweise sind die elektrisch positiv und negativ geladenen Bereiche der Funktionsschicht derart - zumindest mittelbar - an der Unterseite der Trägerplatte angeordnet, dass bei Betreten des Belagselementes durch eine Person sichergestellt werden kann, dass sowohl - zumindest bereichsweise - ein positiv und ein negativ geladener Bereich der Funktionsschicht kontaktiert wird. Dies ist insbesondere für den kapazitiven Sensor vorteilhaft.

In diesem Zusammenhang kann vorgesehen sein, dass die Funktionsschicht zumindest im Wesentlichen vollflächig - zumindest mittelbar - auf der Unterseite der Trägerplatte angeordnet ist und durch wenigstens einen positiv und einen negativ geladenen Bereich gebildet wird. Der positiv und der negativ geladene Bereich können jeweils an einen Längsrand angrenzen und vorzugsweise durch einen zumindest im Wesentlichen linienförmigen, wellenförmigen, zick-zack-förmigen und/oder geschwungenen Trennbereich bzw. Isolierbereich voneinander elektrisch getrennt sein.

In weiteren Ausführungsformen kann der vorgenannte Isolierbereich auch - zumindest bereichsweise, vorzugsweise vollständig - zumindest im Wesentlich rechteckförmig ausgebildet sein.

Des Weiteren betrifft die vorliegende Erfindung ein System mit einer Mehrzahl von Belagselementen, wobei wenigstens ein Belagselement nach einer oder mehreren der zuvor beschriebenen Ausführungsformen ausgebildet ist. Das Belagselement ist mit weiteren Belagselementen zur Bildung eines Belages verbunden. Erfindungsgemäß kann vorgesehen sein, dass die weiteren Belagselemente auch - zumindest teilweise - nach wenigstens einer der zuvor beschriebenen Ausführungsformen ausgebildet sind.

Es versteht sich, dass im Zusammenhang mit dem System auf alle zuvor beschriebenen Vorteile und/oder besonderen Ausführungsformen des erfindungsgemäßen Belagselementes verwiesen werden darf, die in gleicher Weise auch für das erfindungsgemäße System gelten. Zur Vermeidung von unnötigen Wiederholungen sei diesbezüglich somit auf die vorherigen Ausführungsformen verwiesen.

Ferner ist es erfindungsgemäß möglich, dass die weiteren Belagselemente als "Leiterdielen" dienen - das heißt zwar eine Funktionsschicht aufweisen, jedoch keine Messeinrichtung. Letztlich kann das Belagselement die Messeinrichtung aufweisen, wobei durch die unmittelbare Verbindung mit weiteren Belagselementen das durch das Belagselement aufgenommene Messergebnis über die weiteren Belagselemente übertragbar ist und/oder das Belagselement durch die weiteren Belagselemente mit Energie versorgbar ist.

Erfindungsgemäß wird durch das System ein Belag bereitgestellt, der zumindest bereichsweise eine elektrische Funktionalität aufweist. In diesem Zusammenhang müssen nicht zwingend die weiteren Belagselemente eine Funktionsschicht aufweisen.

Insbesondere ist der Funktionsschicht eine, vorzugsweise externe, Energieversorgungseinrichtung zugeordnet. Durch die Energieversorgungseinrichtung, die beispielsweise mit wenigstens einer Funktionsschicht wenigstens eines Belagselementes verbunden ist (beispielsweise über ein Kabel), kann der gesamte Belag und/oder zumindest Bereiche des Belages mit Energie versorgbar sein. Vorzugsweise ist die Energieversorgungseinrichtung elektrisch leitend mit der Funktionsschicht verbunden und/oder induktiv mit der Funktionsschicht gekoppelt.

Die Energieversorgungseinrichtung kann darüber hinaus die für die Messeinrichtung benötigte Energie bereitstellen. Für den kapazitiven Sensor kann die Energieversorgungseinrichtung alternativ oder zusätzlich das benötigte elektrische Feld bereitstellen und/oder den für den Drucksensor benötigten elektrischen Strom übertragen.

Vorteilhaft an der vorgenannten Energieversorgungseinrichtung ist, dass einzelnen Belagselementen nicht jeweils eine Energieversorgungseinrichtung zugeordnet werden muss. Die Belagselemente bzw. die weiteren Belagselementen können - durch ihre elektrische Verbindung und/oder induktive Kopplung untereinander - durch wenigstens eine Energieversorgungseinrichtung gemeinsam versorgt werden. Dies vereinfacht die Bereitstellung eines erfindungsgemäßen Belags bzw. eines erfindungsgemäßen Systems.

Bei der vorgenannten Anordnung des Belagselementes an weitere Belagselemente darf in diesem Zusammenhang ausdrücklich auf die Überlappung der elektrischen Leiterbahnen verwiesen werden. Besonders vorteilhaft zeigt es sich, dass bei einer überlappenden Anordnung der jeweils zueinander korrespondierenden Leiterbahnen unterschiedliche Dicken und/oder Breiten und/oder Längen der Leiterbahnen vorgesehen sind. Auch eine elektrische Isolierung zur Vermeidung eines Kurzschlusses ist vorteilhaft bei der Verbindung des Belagselementes mit den weiteren Belagselementen.

Ferner kann bei einer weiteren Ausgestaltung des Erfindungsgedankens ergänzend zu der Klickverbindung von wenigstens einem Belagselement mit wenigstens einem weiteren Belagselement eine zusätzliche stoffschlüssige Verbindung, vorzugsweise eine Klebverbindung, vorgesehen sein. Insbesondere können die Funktionsschichten und/oder Trägerschichten der Belagselemente miteinander stoffschlüssig, insbesondere verklebt, verbunden sein. Dabei kann vorgesehen sein, dass der überstehende Bereich des Belagselementes zumindest bereichsweise stoffschlüssig mit der weiteren Kontaktierungsfläche des weiteren Belagselementes verbunden ist.

Bei einer weiter bevorzugten Ausgestaltung kann der überstehende Bereich des Belagselementes zumindest bereichsweise als Klebestreifen, vorzugsweise abgedeckt durch einen Liner, ausgebildet sein.

Zur vorgenannten Verklebung kann ein elektrisch leitfähiges und/oder ein nichtleitfähiges Material, insbesondere Klebstoff, vorgesehen sein. Zudem kann die stoffschlüssige Verbindung auch in einer weiteren Ausführungsform lösbar und/oder dauerfest ausgebildet sein.

Vorzugsweise ist der Funktionsschicht wenigstens eine, vorzugsweise externe, Bedienungseinrichtung zur Steuerung der Funktionsschicht zugeordnet. Insbesondere kann durch die Bedienungseinrichtung die Funktionsschicht "aktiviert" werden und/oder, insbesondere zur Aktivierung, mit elektrischer Energie versorgt werden. Letztlich kann über die Bedienungseinrichtung die Messeinrichtung der Funktionsschicht gesteuert und/oder geregelt, insbesondere aktiviert, werden. Darüber hinaus können auch einzelne Bereiche des Belages und/oder einzelne Belagselemente aktiviert werden.

Im Zusammenhang mit der Ausbildung als kapazitiver Sensor der Messeinrichtung kann vorgesehen sein, dass innerhalb eines Belages zwei unterschiedliche Arten von Belagselementen eingesetzt werden können.

Ein Belagselement kann als "Anschlussdiele" dienen, das mit einer Energieversorgungseinrichtung, insbesondere einem externen Stromgerät, zur Versorgung der Funktionsschicht mit elektrischer Ladung und/oder elektrischer Energie verbunden ist. Ferner kann die erste Art des Belagselementes auch mit einer Verarbeitungseinrichtung, insbesondere zur Bestimmung der elektrischen Kapazitätsänderung, koppelbar sein. Vorzugsweise sind wenigstens zwei getrennte elektrisch leitfähige Flächen der Funktionsschicht vorgesehen, die durch die Energieversorgungseinrichtung mit positiver und/oder negativer elektrischer Ladung versorgbar sind, so dass letztlich die Anschlussdiele positiv und negativ geladene Flächen aufweist.

Die zwei getrennten elektrisch leitfähigen Flächen der Anschlussdiele geben die jeweilige Ladung an einen weiteren Typ des Belagselementes, insbesondere eine "Leiterdiele", weiter. Die Leiterdiele kann zur Weiterleitung der elektrischen Ladung und/oder der elektrischen Energie über die elektrische Kontaktierung mit der "Anschlussdiele" dienen, so dass eine Leiterdiele grundsätzlich eine Funktionsschicht aufweisen kann, die aus einer vollständig leitenden Trägerschicht bestehen kann und/oder diese aufweisen kann. Durch die Leiterdielen und insbesondere durch die Weitergabe der elektrischen Ladung und/oder Energie an weitere Belagselemente wird die Sensorfläche vergrößert.

Erfindungsgemäß muss nicht zur Erfassung der kapazitiven Änderungen auf Sensoren mit Spulen oder kapazitiven Drucksensoren zurückgegriffen werden.

Des Weiteren kann der Funktionsschicht, der Messeinrichtung und/oder der Verarbeitungseinrichtung eine, vorzugsweise externe, Steuereinrichtung zugeordnet sein. Insbesondere können die Funktionsschicht, die Messeinrichtung und/oder die Verarbeitungseinrichtung durch die Steuereinrichtung steuerbar und/oder regelbar ausgebildet sein. Vorzugsweise ist die Funktionsschicht, die Messeinrichtung und/oder die Verarbeitungseinrichtung wenigstens eines Belagselementes kabellos mit der Steuereinrichtung verbunden, die die Signale insbesondere an die Übertragungseinrichtung des Belagselementes und/oder an eine Empfängereinrichtung des Belagselementes übertragen kann.

Bei dem erfindungsgemäßen System kann das der Energieversorgungseinrichtung zugeordnete Belagselement als "Anschlussdiele" bezeichnet werden.

Das weitere Belagselement kann insbesondere nicht an eine Energieversorgungseinrichtung angeschlossen werden, so dass das weitere Belagselement letztlich als "Leiterdiele" zur Übertragung von elektrischer Energie, elektrischer Ladung und/oder Informationen ausgebildet ist.

Bei einem durch die Belagselemente und die weiteren Belagselemente gebildeten Belag kann vorgesehen sein, wenigstens ein Belagselement mit der Energieversorgungseinrichtung verbunden ist. Insbesondere ist es erfindungsgemäß nicht nötig, dass alle Belagselemente mit jeweils einer Energieversorgungseinrichtung oder einer gemeinsamen Energieversorgungseinrichtung unmittelbar verbunden sein müssen.

Bei einer weiteren bevorzugten Ausführungsform kann vorgesehen sein, dass wenigstens ein Belagselement - insbesondere entweder das wenigstens eine Belagselement und/oder das weitere Belagselement - als "Anschlussdiele" ausgebildet ist. Die Anschlussdiele kann zur Verbindung und/oder zum Anschluss, insbesondere zum elektrischen Anschluss, an eine externe Einrichtung, beispielsweise eine Energieversorgungseinrichtung, ausgebildet sein. Unter einer externen Einrichtung ist insbesondere ein Element bzw. eine Einrichtung zu verstehen, die letztlich kein erfindungsgemäßes Belagselement darstellt. Die Verbindung zwischen der Anschlussdiele und der externen Einrichtung kann ferner lösbar, bedingt lösbar und/oder dauerfest sein. Mögliche Verbindungen zwischen der Anschlussdiele und der externen Einrichtung können reibschlüssig, kraftschlüssig und/oder stoffschlüssig ausgebildet sein und/oder als Kontaktverbindung, Schraubverbindung, Klettverbindung, Steckverbindung, Nietverbindung, Schweißverbindung, Lötverbindung, Crimpverbindung und/oder Klebverbindung ausgebildet sein.

Vorzugsweise kann die Verbindung zwischen der Anschlussdiele und der externen Einrichtung mehrpolig, insbesondere zweipolig, ausgebildet sein.

Zudem kann die zuvor beschriebene Verbindung zwischen der Anschlussdiele und der externen Einrichtung eine Stromversorgung des Belags und/oder des erfindungsgemäßen Systems ermöglichen. Ferner kann die Verbindung alternativ oder zusätzlich für eine, insbesondere drahtgebundene, Informationsweiterleitung genutzt werden. Die Anschlussdiele und/oder deren Funktionsschicht kann darüber hinaus zumindest bereichsweise eine Kontaktierungsfläche zur Verbindung und/oder Kontaktierung einer anderen Funktionsschicht eines anderen Belagselementes aufweisen.

Sofern als Messeinrichtung ein kapazitiver Sensor vorgesehen ist und/oder die Messeinrichtung einen kapazitiven Sensor aufweist, ist es besonders vorteilhaft, wenn die "Anschlussdiele" bzw. das Belagselement wenigstens einen elektrisch positiv und wenigstens einen elektrisch negativ geladenen Bereich der Funktionsschicht aufweist, insbesondere wobei die positiv und die negativ geladenen Bereiche voneinander elektrisch getrennt sind und/oder gemeinsam zumindest im Wesentlichen vollflächig - zumindest mittelbar - an der Unterseite der Trägerplatte angeordnet sind.

Besonders bevorzugt ist in diesem Zusammenhang, wenn die "Leiterdiele" an der Unterseite der Trägerplatte zumindest im Wesentlich vollflächig eine elektrisch positiv oder negativ geladene Funktionsschicht aufweist, deren Messeinrichtung als kapazitiver Sensor ausgebildet ist, insbesondere so dass die gesamte Funktionsschicht letztlich den kapazitiven Sensor bildet.

Grundsätzlich kann erfindungsgemäß vorgesehen sein, dass, wenn die Messeinrichtung einen kapazitiven Sensor aufweist, die Funktionsschicht elektrisch neutrale Flächen aufweisen kann.

Alternativ oder zusätzlich kann nur eine elektrisch geladene Fläche (positiv oder negativ) vorgesehen sein, die zur Detektion einer Kapazitätsänderung mit einer weiteren elektrisch geladenen Fläche bzw. Bereich der Auswerteeinrichtung zusammenwirken kann. In diesem Zusammenhang kann vorgesehen sein, dass innerhalb eines Systems das den kapazitiven Sensor aufweisende Belagselement ("Anschlussdiele") nur eine elektrisch positiv oder negativ geladene Funktionsschicht bzw. Sensorfläche aufweist.

Des Weiteren betrifft die vorliegende Erfindung ein Verfahren zur Herstellung eines Belagselementes nach einer der zuvor beschriebenen Ausführungsformen, wobei das Verfahren die folgenden Schritte aufweist:
A) Einbringen einer Nut-Feder-Verbindungsgeometrie in eine Trägerplatte, insbesondere zur Ausbildung einer Klickverbindung;
B) Anbringen einer Funktionsschicht unterseitig der Trägerplatte, wobei die Funktionsschicht derart an die Trägerplatte angeordnet wird, dass die Funktionsschicht an wenigstens einer Seite, insbesondere an wenigstens einer Längsseite, im Einbauzustand des Belagselementes über den Seitenrand der Seite, insbesondere der Längsseite, übersteht;
   wobei der Verfahrensschritt B) nachfolgend zu dem Verfahrensschritt A) durchgeführt wird.

Es versteht sich, dass die vorherigen Ausführungen zu Vorteilen und bevorzugten Ausführungsformen des erfindungsgemäßen Belagselementes in gleicher Weise auch für das erfindungsgemäße Verfahren gelten. Zur Vermeidung von unnötigen Wiederholungen darf demzufolge auf die vorangegangenen Erläuterungen ausdrücklich verwiesen werden.

Bei einer weiteren bevorzugten Ausführungsform des Verfahrens kann vorgesehen sein, dass vor dem Verfahrensschritt A) oder nach dem Verfahrensschritt A), insbesondere vor Durchführung des Verfahrensschrittes B), an der Oberseite der Trägerplatte wenigstens ein, vorzugsweise mehrlagiger, Schichtaufbau angeordnet wird. Der Schichtaufbau kann fest mit der Trägerplatte verbunden werden. Der Schichtaufbau kann dabei eine Verschleißschicht, eine Dekorschicht, insbesondere eine Dekorfolie, und/oder eine Deckschicht, insbesondere Overlay, aufweisen.

Der mehrlagige Schichtaufbau und/oder die Lagen des mehrlagigen Schichtaufbaus können insbesondere auf die Trägerplatte aufkaschiert werden. Alternativ oder zusätzlich kann vorgesehen sein, dass eine Echtholzdeckschicht durch eine Schutzschicht und/oder Versiegelung, die oberseitig auf die Echtholzdeckschicht aufgebracht wird, geschützt wird.

Alternativ oder zusätzlich kann auch vorgesehen sein, dass der Schichtaufbau mit der Trägerplatte verpresst wird.

Insbesondere wird der Schritt B) nach dem Aufkaschieren und/oder Verpressen des Schichtaufbaus und der Trägerplatte durchgeführt.

Vorzugsweise wird die Nut-Feder-Verbindungsgeometrie in die Seiten des Belagselementes, insbesondere der Trägerplatte, eingefräst, eingeprägt und/oder eingeschnitten.

Darüber hinaus kann bei einer weiteren bevorzugten Ausgestaltung des Erfindungsgedankens nachfolgend zu dem Verfahrensschritt B) die Funktionsschicht zumindest abschnittsweise an wenigstens einem Seitenrand, insbesondere an einer Federseite, nach unten - d.h. der Trägerplatte abgewandt - umgelegt und/oder umgefaltet werden.

Des Weiteren kann vor dem Verfahrensschritt B) oder nach Durchführung des Verfahrensschrittes B) wenigstens eine Aussparung, insbesondere Ausfräsung, unterseitig in die Trägerplatte eingebracht werden. Die Aussparung kann in die Trägerplatte eingeschnitten, eingefräst und/oder eingeprägt werden. Zudem kann die Aussparung zur Aufnahme eines elektronischen Bauteils vorgesehen sein, das insbesondere darin untergebracht werden kann.

Im Übrigen versteht es sich, dass in den vorgenannten Intervallen und Bereichsgrenzen jegliche Zwischenintervalle und Einzelwerte enthalten und als erfindungswesentlich offenbart anzusehen sind, auch wenn diese Zwischenintervalle und Einzelwerte nicht konkret angegeben sind.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst. Dabei bilden alle beschriebenen und/oder bildlich dargestellten Merkmale für sich oder in beliebiger Kombination den Gegenstand der vorliegenden Erfindung, unabhängig von ihrer Zusammenfassung in den Ansprüchen oder deren Rückbeziehung.

Es zeigt:
- Fig. 1: eine schematische perspektivische Ansicht eines erfindungsgemäßen Belagselementes,
- Fig. 2: eine schematische Querschnittsansicht des in Fig. 1 gezeigten erfindungsgemäßen Belagselementes,
- Fig. 3: eine schematische Querschnittsansicht einer weiteren Ausführungsform des erfindungsgemäßen Belagselementes,
- Fig. 4: eine schematische Querschnittsansicht einer weiteren Ausführungsform eines mit einem weiteren Belagselement verbundenen erfindungsgemäßen Belagselementes,
- Fig. 5: eine schematische Darstellung des erfindungsgemäßen Systems,
- Fig. 6: eine schematische Draufsicht auf einen erfindungsgemäßen Belag,
- Fig. 7: eine schematische perspektivische Darstellung von erfindungsgemäßen Belagselementen gemäß einer weiteren Ausführungsform,
- Fig. 8: eine schematische perspektivische Darstellung von erfindungsgemäßen Belagselementen gemäß einer weiteren Ausführungsform,
- Fig. 9: eine schematische perspektivische Darstellung von erfindungsgemäßen Belagselementen gemäß einer weiteren Ausführungsform,
- Fig. 10: eine schematische perspektivische Darstellung von erfindungsgemäßen Belagselementen gemäß einer weiteren Ausführungsform,
- Fig. 11: eine schematische perspektivische Darstellung von erfindungsgemäßen Belagselementen gemäß einer weiteren Ausführungsform,
- Fig. 12: eine schematische perspektivische Darstellung von erfindungsgemäßen Belagselementen gemäß einer weiteren Ausführungsform,
- Fig. 13: eine schematische Draufsicht auf die Unterseite einer weiteren Ausführungsform des mit weiteren Belagselementen verbundenen erfindungsgemäßen Belagselementes,
- Fig. 14: eine schematische Draufsicht auf die Unterseite einer weiteren Ausführungsform des mit weiteren Belagselementen verbundenen erfindungsgemäßen Belagselementes,
- Fig. 15: eine schematische Draufsicht auf die Unterseite einer weiteren Ausführungsform des mit weiteren Belagselementen verbundenen erfindungsgemäßen Belagselementes,
- Fig. 16: eine schematische perspektivische Darstellung des Schichtaufbaus einer weiteren Ausführungsform des erfindungsgemäßen Belagselementes,
- Fig. 17: eine schematische perspektivische Darstellung des Schichtaufbaus einer weiteren Ausführungsform des erfindungsgemäßen Belagselementes,
- Fig. 18: eine schematische perspektivische Darstellung einer weiteren Ausführungsform des erfindungsgemäßen Belagselementes,
- Fig. 19: eine schematische perspektivische Darstellung der erfindungsgemäßen Trägerschicht,
- Fig. 20: eine schematische perspektivische Darstellung einer weiteren Ausführungsform der erfindungsgemäßen Trägerschicht,
- Fig. 21: eine schematische Darstellung einer weiteren Ausführungsform eines mit einem weiteren Belagselement verbundenen erfindungsgemäßen Belagselementes,
- Fig. 22: eine schematische Darstellung einer weiteren Ausführungsform des erfindungsgemäßen Systems,
- Fig. 23: eine schematische Ansicht des Details A aus Fig. 22,
- Fig. 24: eine schematische Darstellung des erfindungsgemäßen Belagselementes gemäß einer weiteren Ausführungsform,
- Fig. 25: eine schematische Darstellung des erfindungsgemäßen Belagselementes gemäß einer weiteren Ausführungsform,
- Fig. 26: eine schematische Darstellung einer weiteren Ausführungsform des erfindungsgemäßen Systems,
- Fig. 27: eine schematische Darstellung des erfindungsgemäßen Belagselementes gemäß einer weiteren Ausführungsform und
- Fig. 28: eine schematische Darstellung des erfindungsgemäßen Belagselementes gemäß einer weiteren Ausführungsform.

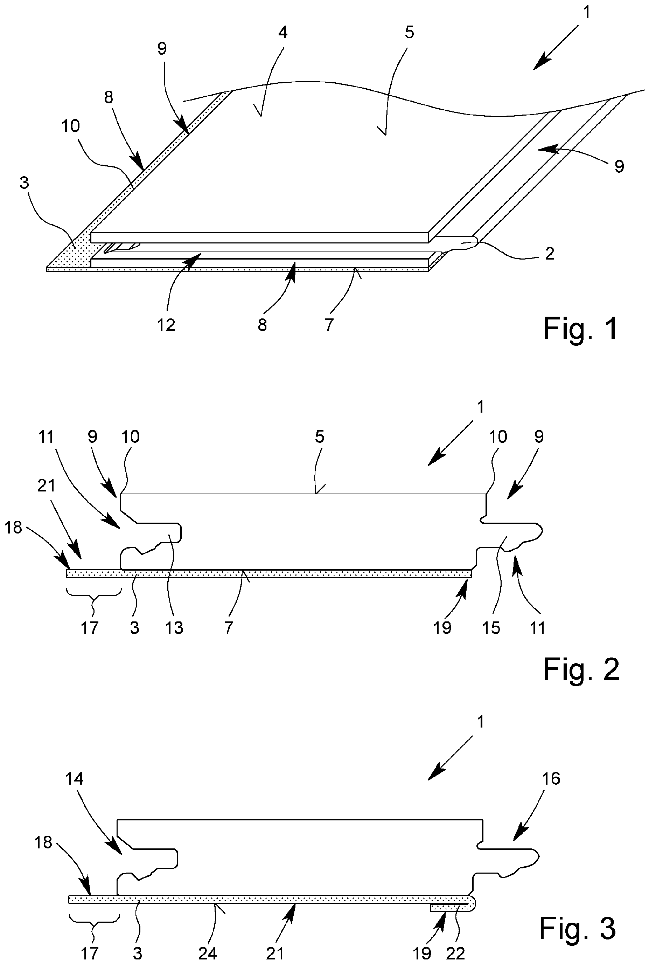

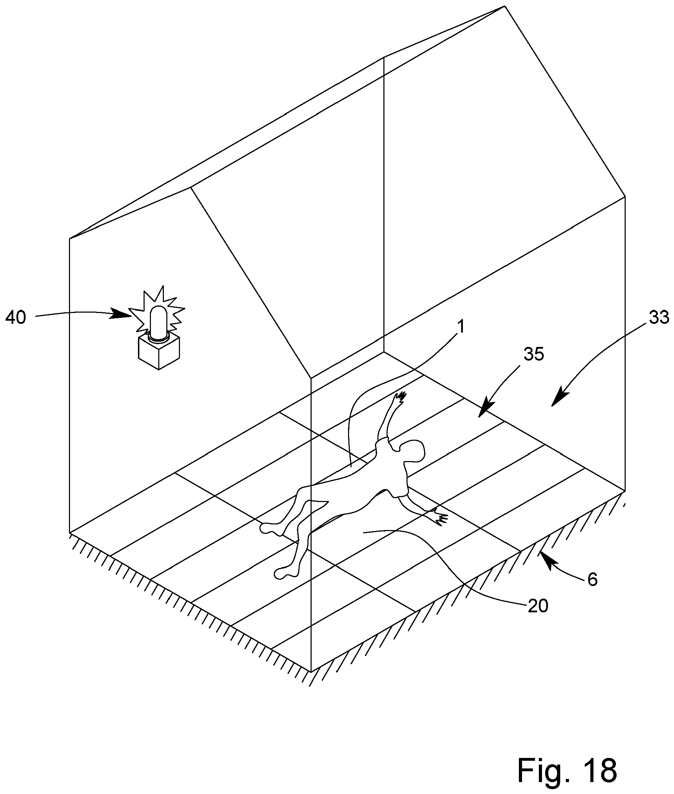

Fig. 1 zeigt ein Belagselement 1 bzw. eine Diele, die zur Verwendung als Boden-, Wand- und Deckenbelagselement für einen Boden-, Wand- und/oder Deckenbelag vorgesehen ist. Der Einsatz des Belagselementes 1 in einem Belag 35 wird beispielsweise in Fig. 18 dargestellt.

Das Belagselement 1 weist wenigstens eine Trägerplatte 2 und wenigstens eine Funktionsschicht 3 auf.

Die Trägerplatte 2 weist eine einer Nutzseite 4 zugewandte Oberseite 5 und eine der Oberseite 5 gegenüberliegende, dem Untergrund 6 zugewandte Unterseite 7 auf. In Fig. 18 ist schematisch dargestellt, dass der Untergrund 6 unterhalb des Belagselementes 1 vorgesehen ist.

Das in Fig. 1 dargestellte Belagselement 1 weist die Funktionsschicht 3 unterhalb der Trägerplatte 2 auf. Die Funktionsschicht 3 ist dabei der Unterseite 7 der Trägerplatte 2 zugewandt.

Des Weiteren ist vorgesehen, dass die Funktionsschicht 3 derart ausgebildet ist, dass sie an wenigstens einer Seite 8 im Einbauzustand des Belagselements 1 zumindest bereichsweise über den Seitenrand 10 der Seite 8 übersteht. Als Seitenrand 10 ist in Fig. 1 die äußerste Kante des Belagselements 1 zu verstehen. In Fig. 1 ist weiter dargestellt, dass die Funktionsschicht 3 an nur einer Längsseite 9 im Einbauzustand über den Seitenrand 10 übersteht. Insbesondere ist vorgesehen, dass gemäß Fig. 1 die Funktionsschicht 3 an wenigstens einer Querseite 12 nicht übersteht. Nicht dargestellt ist, dass die Funktionsschicht 3 an keiner Querseite 12 des Belagselementes 1 übersteht.

Die Funktionsschicht 3 kann als eine zusammenhängende Schicht, insbesondere als eine einzige Schicht, und/oder als eine mehrteilige Schicht, insbesondere wenigstens zwei elektrisch miteinander verbundene Schichten, ausgebildet sein. Die Funktionsschicht 3 kann ferner eine Mehrzahl von voneinander beabstandeten überstehenden Bereichen aufweisen.

In Fig. 1 ist dargestellt, dass die Funktionsschicht 3 unmittelbar an die Trägerplatte 2 angeordnet ist.

Nicht dargestellt ist, dass zwischen der Unterseite 7 der Trägerplatte 2 und der Funktionsschicht 3 wenigstens eine weitere Schicht vorgesehen sein kann.

Darüber hinaus wird aus Fig. 1 ersichtlich, dass an gegenüberliegenden Seiten 8 der Trägerplatte 2, insbesondere sowohl an den Längsseiten 9 als auch an den Querseiten 12, korrespondierende Nut-Feder-Verbindungsgeometrien 11 vorgesehen sind. In dem dargestellten Ausführungsbeispiel dienen die Nut-Feder-Verbindungsgeometrien 11 zur Ausbildung einer Klickverbindung. Über eine derartige Klickverbindung kann das Belagselement 1 mit weiteren Belagselementen 20 verbunden werden.

Nicht dargestellt ist, dass an gegenüberliegenden Seiten 8 der Trägerplatte 2 korrespondierende Druckknopf- oder Bajonettverschlussverbindungsgeometrien vorgesehen sind.

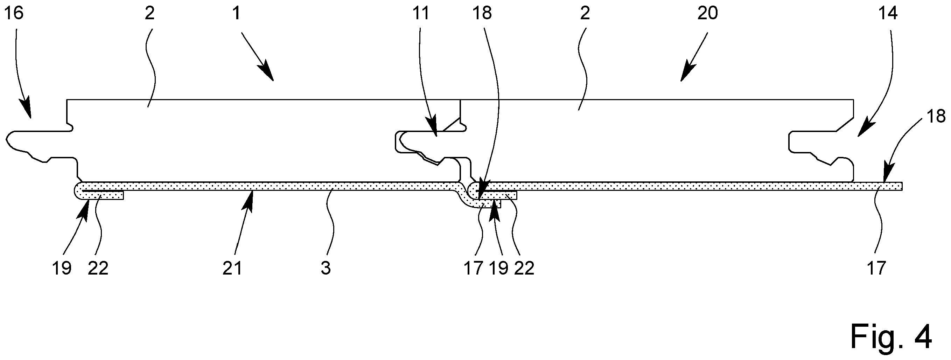

In Fig. 1 und 2 ist dargestellt, dass die Trägerplatte 2 eine eine Nut 13 aufweisende Nutseite 14 und eine der Nutseite 14 gegenüberliegende, eine Feder 15 aufweisende Federseite 16 aufweist. Dabei ist die Nutseite 14 bzw. die Nut 13 korrespondierend zur Federseite 16 bzw. Feder 15 ausgebildet, so dass bei Verbindung der Nutseite 14 mit der Federseite 16 eine Klickverbindung entsteht, wie dies beispielsweise in Fig. 4 ersichtlich ist.

Darüber hinaus geht aus Fig. 2 hervor, dass die Funktionsschicht 3 über den Seitenrand 10 der Nutseite 14 im Einbauzustand übersteht. In Fig. 2 ist weiterhin ersichtlich, dass die Funktionsschicht 3 mit dem Seitenrand 10 der Federseite 16 abschließen kann und insbesondere nicht über den Seitenrand 10 der Federseite 16 übersteht.

Fig. 2 zeigt, dass die Funktionsschicht 3 mit ihrem im Einbauzustand überstehenden Bereich 17 an der Nutseite 14 der Längsseite 9 übersteht. Der überstehende Bereich 17 weist zumindest bereichsweise wenigstens eine Kontaktierungsfläche 18 auf. Die Kontaktierungsfläche 18 ist - in Abhängigkeit der Ausbildung des Belagselementes 1 - elektrisch kontaktierend und/oder elektrisch leitend und/oder induktiv koppelbar ausgebildet.

Des Weiteren zeigt Fig. 2, dass an der der Kontaktierungsfläche 18 gegenüberliegenden Seite 8 an der Funktionsschicht 3 zumindest bereichsweise eine weitere Kontaktierungsfläche 19 vorgesehen ist. Auch die weitere Kontaktierungsfläche 19 kann elektrisch kontaktierend und/oder elektrisch leitend und/oder induktiv koppelbar ausgebildet sein.

Die Kontaktierungsfläche 18 kann auf der Unterseite der Funktionsschicht 3, die der Unterseite 7 der Trägerplatte 2 abgewandt ist, angeordnet sein. Insbesondere kann die Kontaktierungsfläche 18 an der der Unterseite 7 der Trägerplatte 2 zugewandten Oberseite der Funktionsschicht 3 angeordnet sein. Letztlich ist die weitere Kontaktierungsfläche 19 im Bereich des gegenüberliegenden Längsrandbereiches der Funktionsschicht 3 angeordnet.

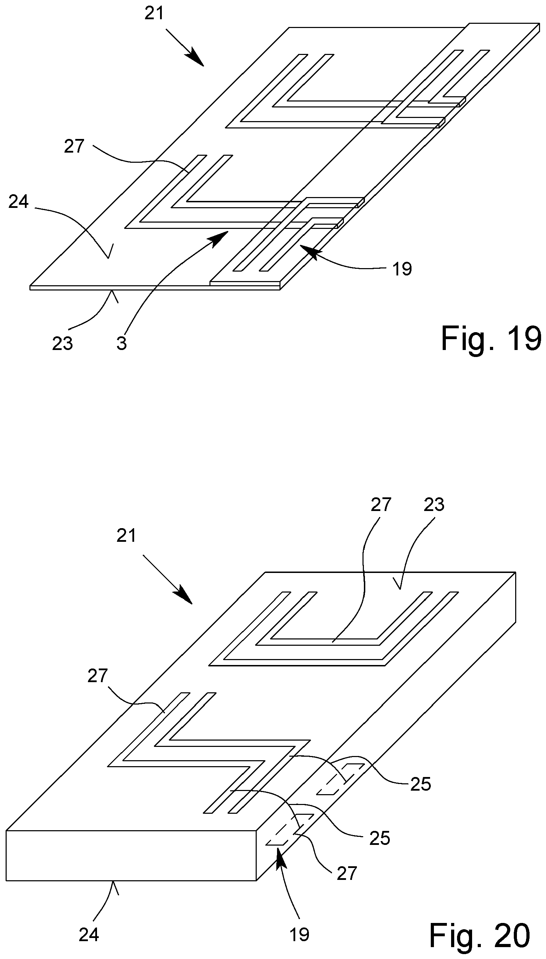

Ferner zeigt Fig. 4, dass die Kontaktierungsfläche 18 und die weitere Kontaktierungsfläche 19 derart korrespondierend zueinander ausgebildet sind, dass im Einbauzustand des Belagselementes 1, bei dem das Belagselement 1 mit wenigstens einem weiteren Belagselement 20 verbunden ist, die Kontaktierungsfläche 18 des Belagselementes 1 mit der weiteren Kontaktierungsfläche 19 eines weiteren mit dem Belagselement 1 verbundenen Belagselementes 20 elektrisch leitend verbunden und/oder induktiv gekoppelt ist. Insbesondere kann die Kontaktierungsfläche 18 zumindest bereichsweise unmittelbar an der weiteren Kontaktierungsfläche 19 des weiteren Belagselementes 20 im Einbauzustand angeordnet sein, wie dies Fig. 20 zeigt.

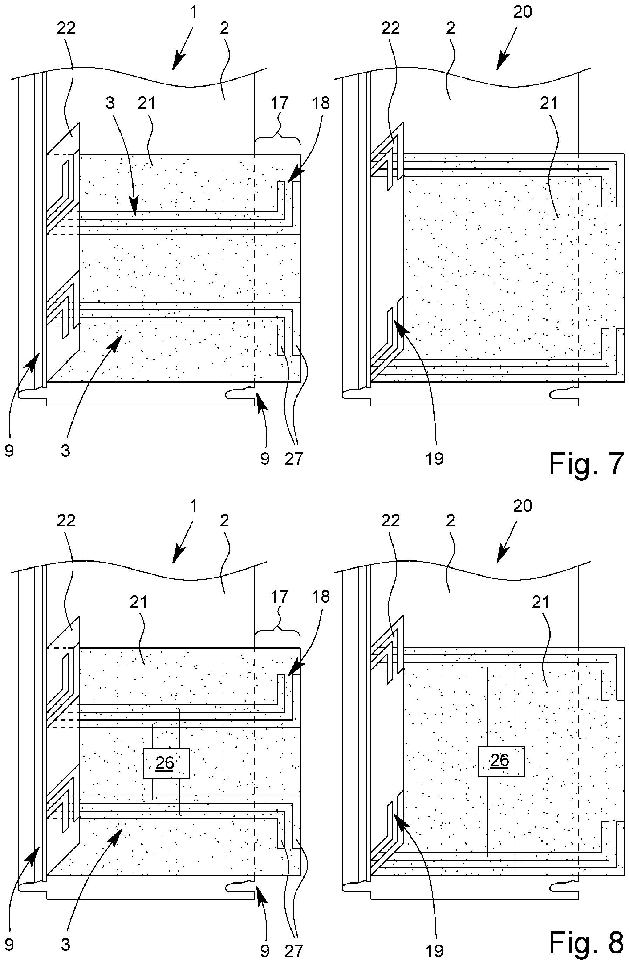

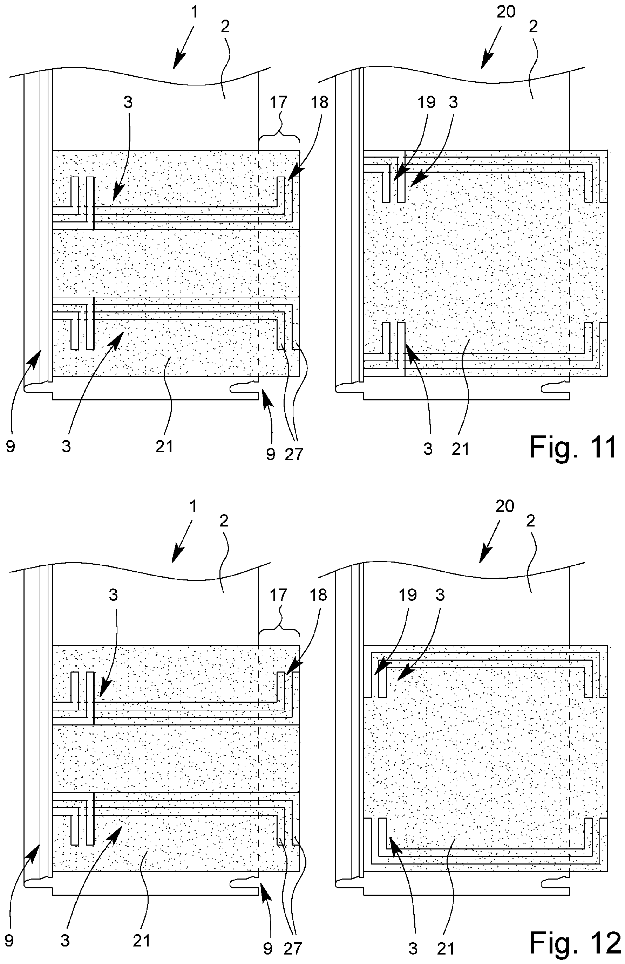

Die Ausbildung der Funktionsschichten 3 des Belagselementes 1 und des weiteren Belagselementes 20 sind in Fig. 4 und in den nachfolgenden Fig. 7 bis 15 schematisch gezeigt. Insbesondere ist in den Fig. 4 und 7 bis 15 die Trägerschicht 21 und/oder die Funktionsschicht 3 schematisch vergrößert dargestellt, um letztlich die Erfindung besser zu verdeutlichen.

Im Einbauzustand kann vorgesehen sein, dass der überstehende Bereich 17, der zumindest bereichsweise die Kontaktierungsfläche 18 aufweist, unterhalb der weiteren Kontaktierungsfläche 19, dem Untergrund 6 zugewandt, angeordnet ist, wobei die weitere Kontaktierungsfläche 19 des weiteren Belagselementes 20 oberhalb des überstehenden Bereichs 17 im verbundenen Zustand angeordnet werden kann. Letztlich kann das weitere Belagselement 20 über seine Federseite 16 in die Nutseite 14 des Belagselementes 1 eingeschwenkt werden, wodurch sich die weitere Kontaktierungsfläche 19 auf der bzw. oberhalb der Kontaktierungsfläche 18 anordnet.

Fig. 4 zeigt, dass die Kontaktierungsfläche 18 zumindest bereichsweise unmittelbar angrenzend an die weitere Kontaktierungsfläche 19 des weiteren Belagselementes 20 im Einbauzustand angeordnet ist. Über die Anordnung der Kontaktierungsfläche 18 und der weiteren Kontaktierungsfläche 19 sind das Belagselement 1 und das damit verbundene weitere Belagselement 20 elektrisch leitend und/oder induktiv gekoppelt verbunden.

Aus Fig. 4 wird ferner ersichtlich, dass die Kontaktierungsfläche 18 an der Nutseite 14 der Längsseite 9 angeordnet ist. Die Kontaktierungsfläche 18 und die weitere Kontaktierungsfläche 19 des weiteren Belagselementes 20 sind übereinander bzw. aufeinander angeordnet, wobei auch durch die Verbindung des Belagselementes 1 mit dem weiteren Belagselement 20 ein "Aufeinanderpressen" der Kontaktierungsfläche 18 und der weiteren Kontaktierungsfläche 19 bzw. der Funktionsschicht 3 des weiteren Belagselementes 20 mit dem überstehenden Bereich 17 der Funktionsschicht 3 des Belagselementes 1 hervorgerufen wird.

Die Trägerschicht 21 kann vollflächig, wie in Fig. 1 dargestellt, an der Unterseite 7 der Trägerplatte 2 zumindest mittelbar angeordnet sein. In weiteren Ausführungsformen, wie beispielsweise in Fig. 7 dargestellt, kann die Trägerschicht 21 auch zumindest bereichsweise an der Unterseite 7 der Trägerplatte 2 angeordnet sein.

Fig. 7 zeigt, dass die Funktionsschicht 3 auf einer Trägerschicht 21 angeordnet ist. Die Funktionsschicht 3 kann fest mit der Trägerschicht 21 verbunden sein. Fig. 3 zeigt wiederum, dass die Trägerschicht 21 aus der Funktionsschicht 3 gebildet ist bzw. daraus besteht.

Zudem zeigt Fig. 20 schematisch, dass die weitere Kontaktierungsfläche 19 an der der Trägerplatte 2 abgewandten Seite der Trägerschicht 21 - nämlich der Unterseite 24 - angeordnet ist.

Fig. 19 zeigt, dass die Trägerschicht 21 einseitig - nämlich auf der Oberseite 23 - mit der Funktionsschicht 3 versehen ist.

Fig. 7 zeigt, dass die Trägerschicht 21 federseitig zumindest abschnittsweise eingefaltet und/oder umgeklappt ist. Bei einem eingeklappten und/oder umgeklappten Bereich 22 der Trägerschicht 21 ergibt sich bei Anordnung des Belagselementes 1 an ein weiteres Belagselement 20 eine elektrisch leitende Verbindung, wie dies aus Fig. 4 ersichtlich wird.

Die weitere Kontaktierungsfläche 19 kann auf dem der Trägerplatte 2 abgewandten, eingeklappten und/oder umgefalteten Bereich 22 der Trägerschicht 21 vorgesehen sein, wie dies die Fig. 4 und 7 verdeutlichen.

In Abhängigkeit der Faltlinie und/oder Falzung im Übergangsbereich bzw. am Knick des eingeklappten Bereichs 22 kann eine im Einbauzustand hervorgerufene Rückstellkraft des eingeklappten Bereichs 22 vorgesehen sein, die zusätzlich zur Gravitationskraft einen besseren Anpressdruck und insbesondere eine verbesserte elektrische Kontaktierung zwischen dem Belagselement 1 und dem weiteren Belagselement 20 ermöglicht.

Durch ein Umklappen der Trägerschicht 21 kann eine - wie in Fig. 19 dargestellte - einseitige Anordnung der Funktionsschicht 3 auf der Trägerschicht 21 vorgesehen sein.

Die Funktionsschicht 3 kann auf der Trägerschicht 21 einseitig und/oder beidseitig angeordnet sein. Bei der in den Fig. 7 und 8 dargestellten einseitigen Anordnung der Funktionsschicht 3 ist vorgesehen, dass die Funktionsschicht 3 an der der Unterseite 7 der Trägerplatte 2 zugewandten Oberseite 23 der Trägerschicht 21 angeordnet ist. In den Fig. 7 bis 12 ist die mit der Funktionsschicht 3 versehene Trägerschicht 21 des Belagselementes 2 unterschiedlich zu der des weiteren Belagselementes 20 ausgebildet, insbesondere im Hinblick auf die Anordnung und Ausbildung der elektrischen Leiterbahnen 27.

In weiteren, nicht dargestellten Ausführungsformen kann vorgesehen sein, dass die mit der Funktionsschicht 3 versehene Trägerschicht 21 des Belagselementes 1 und des weiteren Belagselementes 20, das im Einbauzustand mit dem Belagselement 1 verbunden ist, zumindest im Wesentlichen baugleich ausgebildet ist.

Fig. 20 zeigt schematisch, dass die Funktionsschicht 3 der Oberseite 23 der Trägerschicht 21 mit der Funktionsschicht 3 der Unterseite 24 der Trägerschicht 21 mittels eines Verbindungsmittels 25 elektrisch leitend und/oder induktiv gekoppelt verbunden ist. Als Verbindungsmittel können in weiteren, nicht dargestellten Ausführungsformen Nieten, Krampen und/oder anderweitige Verbindungsmöglichkeiten vorgesehen sein. Letztlich wird über das Verbindungsmittel 25 eine elektrische Kontaktierung der beiden Funktionsschichten 3, die jeweils an eine und/oder an dieselbe Trägerschicht 21 angeordnet sind, ermöglicht.

Nicht dargestellt ist, dass die Trägerschicht 21 zumindest bereichsweise ein elektrisch leitendes und/oder ein elektrisch isolierendes Material aufweist. Als elektrisch nicht leitendes Material der Trägerschicht 21 kann ein Kunststoffmaterial und/oder ein Holz, Papier, Karton, Kork, Filz und/oder Glas aufweisendes und/oder daraus bestehendes Material vorgesehen sein. Als leitendes Material kann für die Trägerschicht ein metallhaltiges Material, wie Aluminium, Kupfer, Silber und/oder Gold, vorgesehen sein. Es versteht sich, dass auch Legierung der vorgenannten Metalle ohne weiteres möglich sind. Sofern die Trägerschicht 21 zumindest bereichsweise ein elektrisch leitendes Material aufweist, kann die Trägerschicht 21 zumindest in diesen Bereichen die Funktionsschicht 3 bzw. einen Bestandteil der Funktionsschicht 3 bilden.

In Fig. 8 ist schematisch dargestellt, dass die Funktionsschicht 3 wenigstens eine Messeinrichtung 26 aufweist, die insbesondere an der der Unterseite 7 der Trägerplatte 2 zugewandten Oberseite 24 der Trägerschicht 21 angeordnet ist. Die Messeinrichtung 26 kann dabei mit Leiterbahnen 27 der Funktionsschicht 3 verbunden sein.

Die in Fig. 8 schematisch dargestellte Messeinrichtung 26 kann als Drucksensor ausgebildet sein. Alternativ oder zusätzlich kann vorgesehen sein, dass die Messeinrichtung 26 einen kapazitiven Sensor aufweist und/oder daraus gebildet ist. Bei der in Fig. 1 dargestellten Ausführungsform ist vorgesehen, dass sich ein kapazitiver Sensor der Messeinrichtung 26 vollflächig über die Funktionsschicht 3 erstreckt, wobei die Trägerschicht 21 aus der Funktionsschicht 3 besteht. Bei einem kapazitiven Sensor kann letztlich die gesamte Fläche der Funktionsschicht 3 zur Messung der Kapazitätsänderung dienen. Bei der in Fig. 8 dargestellten Ausführungsform ist vorgesehen, dass die Messeinrichtung 26 einen Drucksensor aufweist, der, insbesondere zur Energieversorgung, mit den Leiterbahnen 27 der Funktionsschicht 3 verbunden ist. Bei der Ausbildung der Funktionsschicht 3 als kapazitiver Sensor kann vorgesehen sein, dass sich die Kontaktierungsfläche 18 über den gesamten überstehenden Bereich 17 der Funktionsschicht 3 erstreckt. Bei der Messeinrichtung 26 kann vorgesehen sein, dass diese zur Erfassung der auf das Belagselements 1 wirkenden Druckänderung oder Kapazitätsänderung (kapazitiver Sensor) ausgebildet ist. In weiteren, nicht dargestellten Ausführungsformen kann vorgesehen sein, dass die Messeinrichtung 26 zur Ermittlung der Temperatur und/oder der Feuchtigkeit ausgebildet ist. Insbesondere kann die Messeinrichtung 26 fest mit der Trägerschicht 21 verbunden sein.

Darüber hinaus ist bei der in Fig. 1 dargestellten Ausführungsform des kapazitiven Sensors vorgesehen, dass sich dieser zumindest im Wesentlichen vollflächig über die Trägerschicht 21 erstreckt.

Fig. 18 zeigt einen Belag 35, der wenigstens ein Belagselement 1 aufweist, das zur Erfassung der auf das Belagselement 1 wirkenden Druckänderung ausgebildet ist. Beispielsweise kann durch das Belagselement 1 detektiert werden, ob eine, insbesondere gebrechliche und/oder morbide, Person für eine längere Zeit, beispielsweise für über eine Minute, auf dem Boden (Belag 35) liegt. Dies kann gegebenenfalls zu einer Alarmierung bzw. Signalaussendung führen, wie aus Fig. 18 schematisch ersichtlich ist.

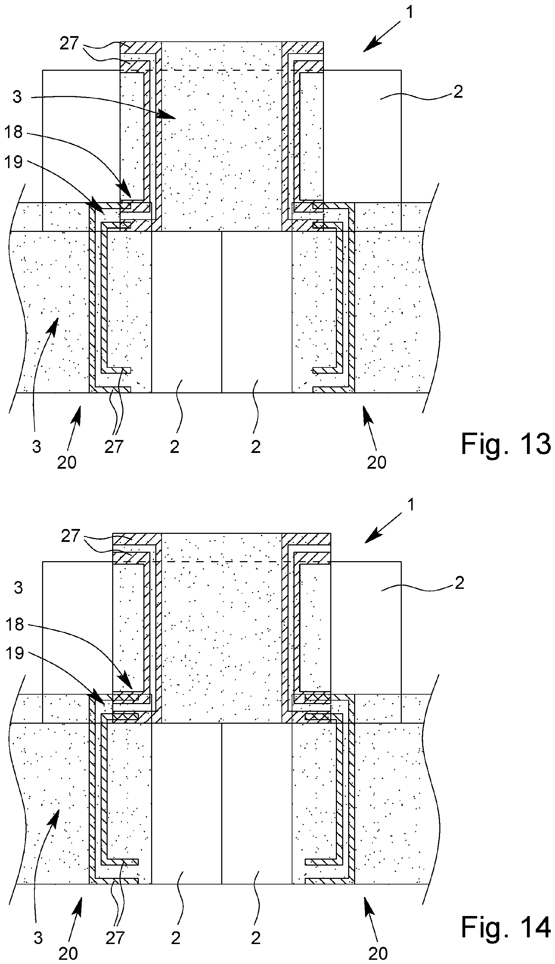

Fig. 7 zeigt, dass an der Trägerschicht 21 wenigstens zwei Leiterbahnen 27 der Funktionsschicht 3 angeordnet sind. In Fig. 7 ist weiter dargestellt, dass jeweils zwei Paare von Leiterbahnen 27 der Funktionsschicht 3 an der Trägerschicht 21 angeordnet sind. In den Fig. 13 bis 15 ist dargestellt, dass jeweils ein Paar der Leiterbahnen 27 des Belagselementes 1 zu jeweils einem weiteren Paar der Leiterbahnen 27 eines weiteren Belagselementes 20 korrespondiert.

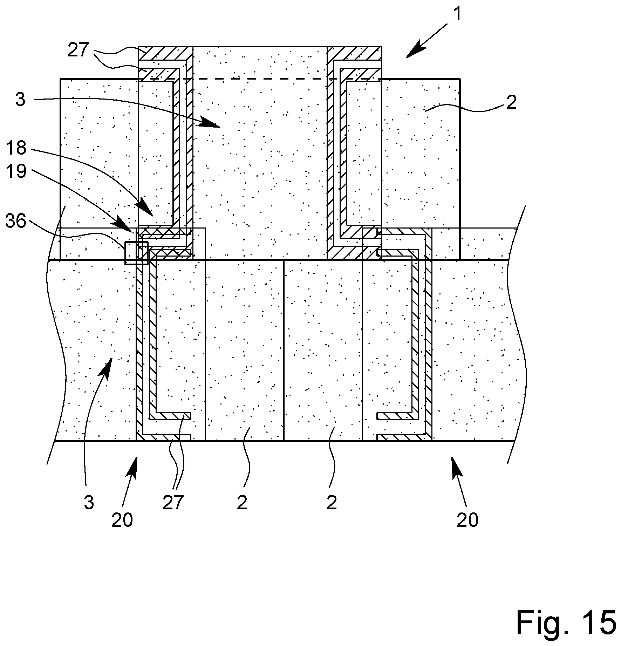

In Fig. 15 ist dargestellt, dass die Leiterbahnen 27 in wenigstens einer Kontaktierungsfläche 18 und/oder wenigstens einer weiteren Kontaktierungsfläche 19 zumindest bereichsweise elektrisch isoliert sind, so dass ein elektrisch isolierter Bereich 36 vorhanden ist.

Nicht dargestellt ist, dass die elektrische Isolierung durch einen Lack hervorgerufen werden kann. Insbesondere ist der elektrisch isolierte Bereich 36 in denjenigen Bereich(en) vorgesehen, an dem/denen andernfalls - bei Überlappung mit weiteren Leitungsbahnen 27 - ein Kurzschluss entstehen würde.

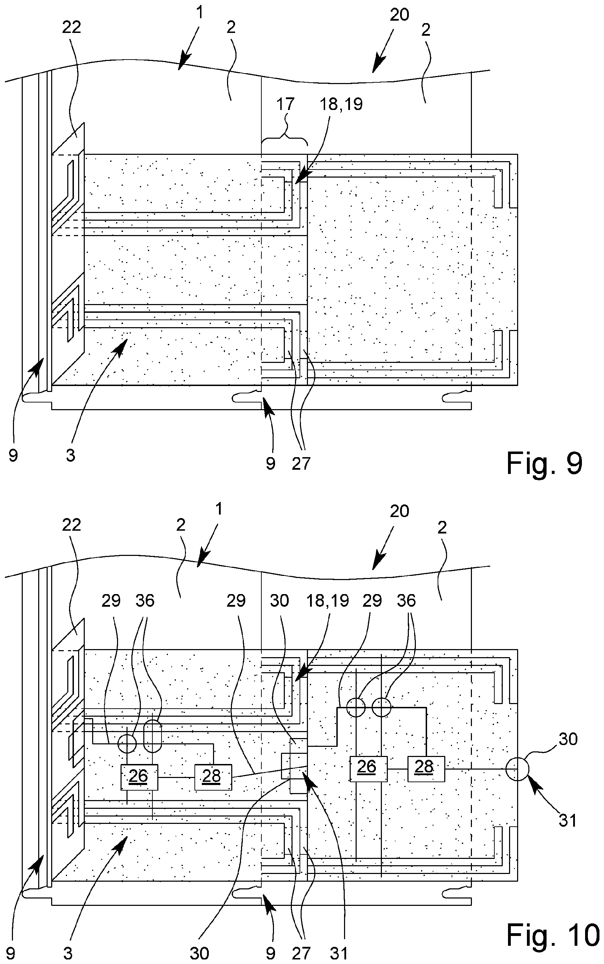

Bei der in den Fig. 9, 10, 13 und 14 dargestellten Kontaktierung der Leiterbahnen 27 ist nicht zwingend ein elektrisch isolierter Bereich 36 vorgesehen, da keine unerwünschte Überlappung der Leiterbahnen 27 auftritt bzw. vorhanden ist. Letztlich ist bei Verbindung des Belagselementes 1 mit dem weiteren Belagselement 20 vorgesehen, dass sich die jeweiligen Leiterbahnen 27 mit jeweils dazu korrespondierenden Leiterbahnen 27 elektrisch verbinden.

Bei der nicht dargestellten baugleichen Ausbildung des Belagselementes 1 und des weiteren Belagselementes 20 ist insbesondere vorgesehen, dass an bzw. auf der Funktionsschicht 3 elektrisch isolierte Bereiche 36 angeordnet sind. Die elektrisch isolierten Bereiche 36 verhindern einen Kurzschluss bei der elektrischen Verbindung des Belagselementes 1 und des weiteren Belagselementes 20.

Fig. 9 zeigt, dass die Leiterbahnen 27 derart in wenigstens einer Kontaktierungsfläche 18 und/oder einer weiteren Kontaktierungsfläche 19 angeordnet sind, dass sie im Einbauzustand des Belagselementes 1 mit den jeweiligen Leiterbahnen 27 eines mit dem Belagselement 1 verbundenen weiteren Belagselementes 20 elektrisch leitend verbunden und/oder induktiv gekoppelt sind. Fig. 9 zeigt weiter, dass die Leiterbahnen 27 des Belagselementes 1 mit den Leiterbahnen 27 des weiteren Belagselementes 20 überlappend angeordnet sind.

Fig. 10 zeigt, dass der Funktionsschicht 3 und/oder der Messeinrichtung 26 eine Verarbeitungseinrichtung 28 zugeordnet ist. Im dargestellten Ausführungsbeispiel ist schematisch gezeigt, dass die Verarbeitungseinrichtung 28 als Teil der Funktionsschicht 3 ausgebildet ist und insbesondere unmittelbar an die Trägerschicht 21 angeordnet ist. Die Verarbeitungseinrichtung 28 ist zur Verarbeitung der von der Messeinrichtung 26 aufgenommenen Informationen ausgebildet.

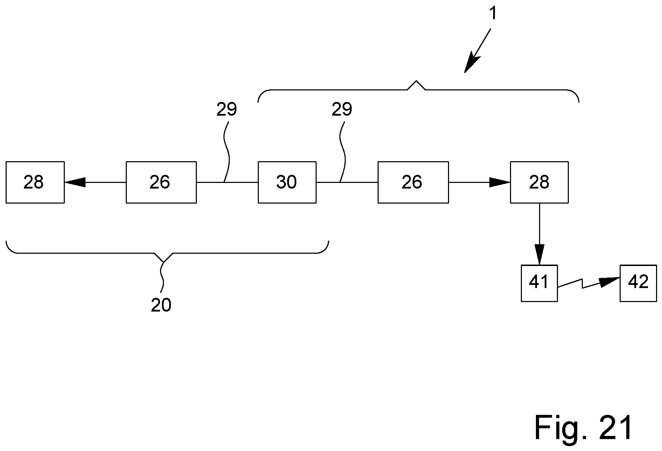

In Fig. 21 ist schematisch dargestellt, dass die Verarbeitungseinrichtung 28 die von der Messeinrichtung empfangenen und verarbeiteten Informationen an eine Übertragungseinrichtung 41 übertragen kann, die, insbesondere kabellos, wiederum an eine Auswerteeinrichtung 42 die Informationen übertragen kann. Die Auswerteeinrichtung 42 kann dem Belagselement 1 zugeordnet sein. Allerdings kann vorgesehen sein, dass die Auswerteeinrichtung 42 nicht innerhalb des Schichtaufbaus des Belagselementes 1 - also extern - angeordnet ist.

Darüber hinaus zeigen die Fig. 10 und 21, dass die Verarbeitungseinrichtung 28 mit wenigstens einer Informationsübertragungsleitung 29 zur Übertragung der durch die Messeinrichtung 26 aufgenommenen, insbesondere durch die Verarbeitungseinrichtung 28 verarbeiteten, Informationen ausgebildet ist. Die Informationsübertragungsleitung 29 kann dabei mit der Messeinrichtung 26 und/oder mit der Verarbeitungseinrichtung 28 verbunden sein. Im dargestellten Ausführungsbeispiel ist die Informationsübertragungsleitung 29 mit der Verarbeitungseinrichtung 28 verbunden.

Über die Informationsübertragungsleitung 29 können die durch die Messeinrichtung 26 aufgenommenen Informationen übertragen werden. Zur Übergabe bzw. Weiterleitung der Informationen von dem Belagselement 1 an ein weiteres Belagselement 20 kann wenigstens ein Kontaktierungsbereich 31 und eine Informationsübertragungsschnittstelle 30 vorgesehen sein. Dabei kann die Informationsübertragungsschnittstelle 30 sowohl an dem Belagselement 1 als auch an dem weiteren Belagselement 20 vorgesehen sein. Weiterhin kann vorgesehen sein, dass die Informationsübertragungsschnittstelle 30 sowohl Teil des Belagselementes 1 als auch des weiteren Belagselementes 20 ist, so dass die Informationsübertragungsschnittstellen 30 den Kontaktierungsbereich 31 bilden. Über die Informationsübertragungsschnittstelle 30 sind die Informationen von dem Belagselement 1 an ein weiteres Belagselement 20 übertragbar oder vice versa.

Nicht dargestellt ist, dass auch kabellos die Informationen über die Informationsübertragungsschnittstelle 30 übertragbar sind, insbesondere kann eine Übertragung der Informationen per Funk, vorzugsweise über eine Antenne, erfolgen.

Bei der in Fig. 10 dargestellten Ausführungsform ist als Messeinrichtung 26 ein Drucksensor vorgesehen, der mit wenigstens zwei Leiterbahnen 27 - im dargestellten Ausführungsbeispiel mit vier Leitungsbahnen 27 - elektrisch leitend verbunden ist. Darüber hinaus kann vorgesehen sein, dass auch an der Informationsübertragungsleitung 29 isolierte Bereiche 36 angeordnet sind, insbesondere im Bereich der Überschneidung mit den Leiterbahnen 27 und/oder weiteren Informationsübertragungsleitungen 29.

Darüber hinaus können die Leiterbahnen 27 mehrpolig und/oder verschiedenpolig ausgebildet sein. Auch die Breite der Leiterbahnen 27, insbesondere in der Kontaktierungsfläche 18, im Kontaktierungsbereich 31 und/oder in der weiteren Kontaktierungsfläche 19 kann variieren. In Fig. 15 ist beispielsweise dargestellt, dass im Bereich der Kontaktierungsfläche 18 die elektrischen Leiterbahnen 27 eine größere Dicke als die Leiterbahnen 27 im Bereich der weiteren Kontaktierungsfläche 19 aufweisen, insbesondere eine zwischen 10 % bis 200 % erhöhte bzw. vergrößerte Dicke bzw. Breite. Dies ist dahingehend vorteilhaft, da bei Verlegung eine ein gewisses Spiel aufweisende Verlegetoleranz ermöglicht wird, bei der die elektrische Kontaktierung dennoch hinreichend gewährleistet werden kann.

Nicht dargestellt ist, dass die Funktionsschicht 3 eine gedruckte Schaltung aufweist und/oder durch eine gedruckte Schaltung gebildet ist.

Weiterhin ist nicht dargestellt, dass die Funktionsschicht 3 unmittelbar auf die Trägerschicht 21 aufgedruckt ist. Als Druck kann beispielsweise Digitaldruck, Siebdruck und/oder Rollenoffsetdruck vorgesehen sein. Insbesondere kann als Material für die Funktionsschicht 3 ein durch Drucken aufbringbares und leitfähiges Material, insbesondere ein Silberpigmente aufweisendes Tintenmaterial, vorgesehen sein.

Ferner ist nicht dargestellt, dass die Trägerschicht 21 mit ihrer der Trägerplatte 2 zugewandten Oberseite 23 als separate Schicht zur Verbindung mit einer weiteren Schicht des Belagselementes 1, insbesondere der Trägerplatte 2, ausgebildet ist. Dabei kann vorgesehen sein, dass die Oberseite 23 und/oder die Unterseite 24 der Trägerschicht 21 zumindest bereichsweise als Klebefolie ausgebildet ist. Insbesondere kann die Trägerschicht 21 als Klebeschicht bzw. Klebefolie ausgebildet sein.

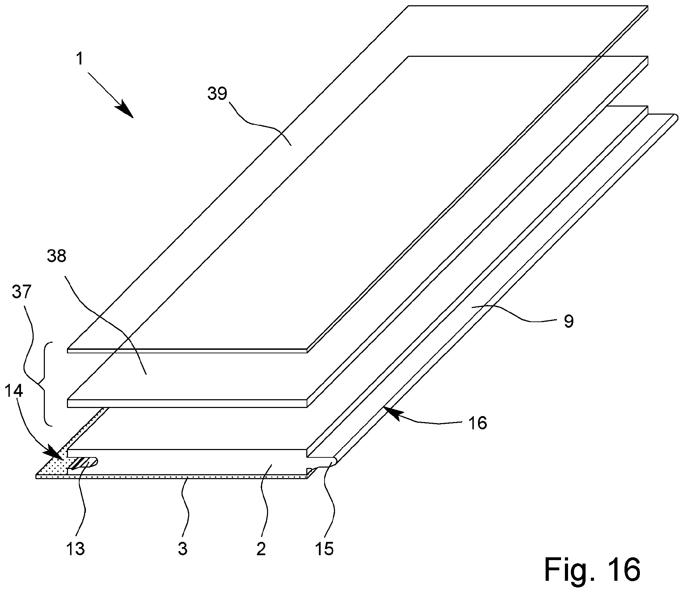

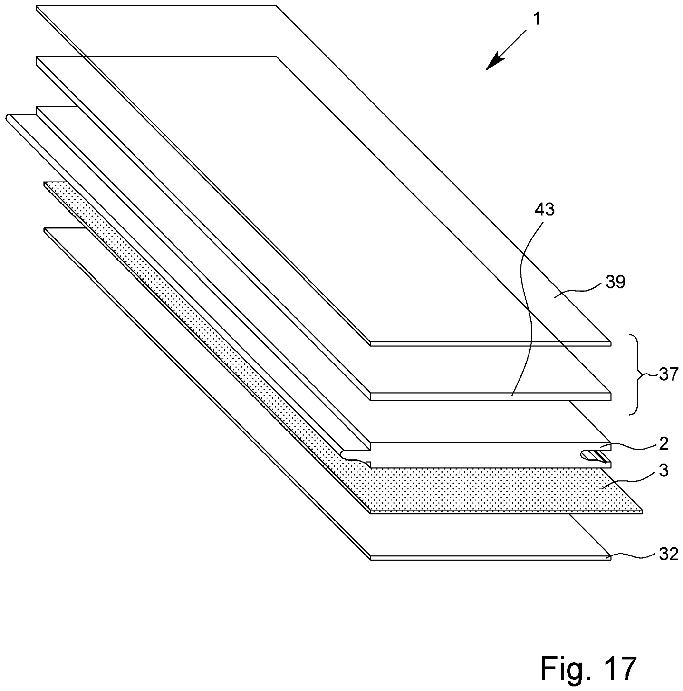

Die Fig. 16 und 17 zeigen, dass an der Oberseite 5 der Trägerplatte 2 wenigstens ein Schichtaufbau angeordnet ist. In den dargestellten Ausführungsbeispielen ist ein mehrlagiger Schichtaufbau 37 vorgesehen. Der mehrlagige Schichtaufbau 37 kann fest mit der Trägerplatte 2 verbunden sein.

Bei dem in Fig. 16 dargestellten Ausführungsbeispiel ist die Ausbildung des Belagselementes 1 als Parkett-Belagselement vorgesehen. Bei dem in Fig. 17 dargestellten Ausführungsbeispiel ist die Ausbildung des Belagselementes 1 als Laminat-Belagselement vorgesehen.

Fig. 16 zeigt, dass der mehrlagige Schichtaufbau 37 wenigstens eine Echtholzdeckschicht 38 aufweist. In Fig. 17 wiederum ist vorgesehen, dass der mehrlagige Schichtaufbau 37 eine Dekorschicht 43, insbesondere eine Dekorfolie, aufweist.

Darüber hinaus kann der mehrlagige Schichtaufbau 37 eine Schutzschicht 39 aufweisen, wobei die Schutzschicht 39 als Overlay 39 und als Verschleißschicht, die insbesondere Korund-Partikel aufweist, ausgebildet sein kann. Die Verschleißschicht 39 kann zum Schutz der Echtholzdeckschicht 38 und/oder der Dekorschicht 43 ausgebildet sein.

Unterhalb der Trägerplatte 2 kann ein Gegenzug 32 angeordnet sein. Der Gegenzug 32 ist der Unterseite 7 der Trägerplatte 2 zugewandt. In dem in Fig. 17 dargestellten Ausführungsbeispiel ist als Gegenzug 32 ein Kraftpapier vorgesehen. Die Funktionsschicht 3 kann - wie aus Fig. 17 ersichtlich - zwischen dem Gegenzug 32 und der Trägerplatte 2 angeordnet sein, vorzugsweise unmittelbar angeordnet an die Trägerplatte 2.

Nicht dargestellt ist, dass die Funktionsschicht 3 auch unterhalb des Gegenzugs 32 angeordnet sein kann und/oder dass die Trägerschicht 21 und/oder die Funktionsschicht 3 den Gegenzug 32 bilden kann.

Weiter nicht dargestellt ist, dass der Schichtaufbau des Belagselementes 1 eine Dämpfungsschicht aufweist. Die Dämpfungsschicht kann der Unterseite 7 der Trägerplatte 2 zugewandt sein. Vorzugsweise kann die Dämpfungsschicht an dem Gegenzug 32 angeordnet sein. Als Dämpfungsschicht kann eine Kunststoff aufweisende Folienschicht und/oder eine Schaumstoff aufweisende Schicht vorgesehen sein. Des Weiteren ist es alternativ oder zusätzlich möglich, dass die Dämpfungsschicht als Trägerschicht 21 ausgebildet ist und/oder dass die Funktionsschicht 3 und/oder die Trägerschicht 21 fest, vorzugsweise unmittelbar, mit der Dämpfungsschicht verbunden ist/sind.

Ferner ist nicht dargestellt, dass die Trägerplatte 2 als HDF-Platte, Echtholzschicht und/oder MDF-Platte ausgebildet sein kann.

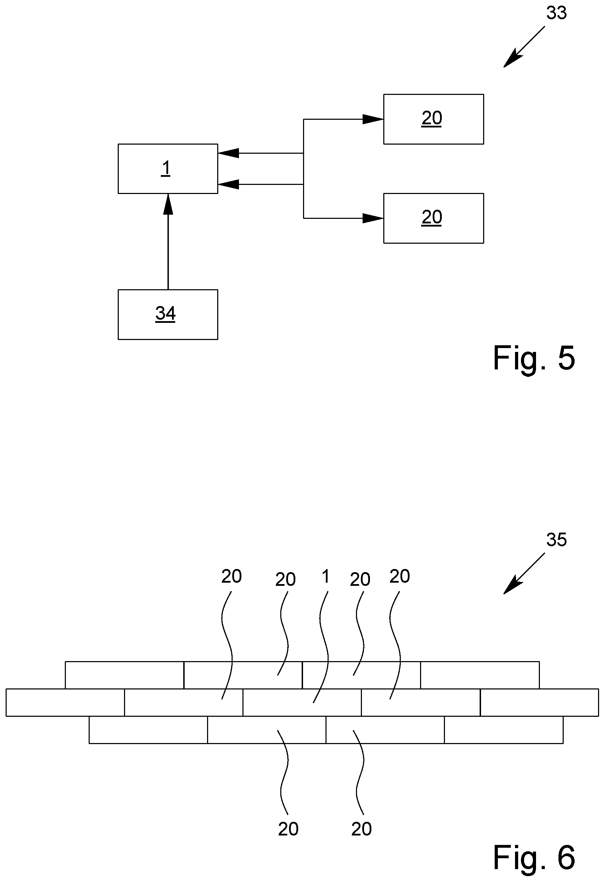

Fig. 5 zeigt ein System 33 mit einer Mehrzahl von Belagselementen 1. Wenigstens ein Belagselement 1 ist nach wenigstens einer der zuvor beschriebenen Ausführungsformen ausgebildet. Das Belagselement 1 kann mit weiteren Belagselementen 20 zur Bildung eines Belags 35 verbunden sein. Der so gebildete Belag 35 ist beispielweise schematisch in Fig. 6 dargestellt.

Die weiteren Belagselemente 20 können eine Messeinrichtung 26 aufweisen und/oder zur Informationsübertragung der von der Messeinrichtung 26 des Belagselementes 1 aufgenommenen Informationen und/oder zur Energieübertragung vorgesehen sein.

Zudem zeigt Fig. 5, dass der Funktionsschicht 3 des Belagselementes 1 eine, vorzugsweise externe, Energieversorungseinrichtung 34 zugeordnet ist. Die Energieversorgungseinrichtung 34 muss dabei nicht Bestandteil des Belagselementes 1 sein. Durch die Energieversorgungseinrichtung 34 kann die Funktionsschicht 3 bzw. das Belagselement 1 mit Energie versorgbar sein, wobei die Energieversorgungseinrichtung 34 elektrisch leitend und/oder induktiv mit der Funktionsschicht 3 gekoppelt sein kann.

Letztlich kann bei dem System 33 vorgesehen sein, dass einem Belagselement 1 die Energieversorgungseinrichtung 34 zugeordnet ist. Das weitere Belagselement 20 muss letztlich nicht an eine Energieversorgungseinrichtung 34 angeschlossen sein und/oder diese aufweisen. Bei einem durch das Belagselement 1 und das weitere Belagselement 20 gebildeten Belag 35 ist es insbesondere ausreichend, wenn nur ein Belagselement 1 mit der Energieversorgungseinrichtung 34 verbunden ist bzw. diese dem Belagselement 1 zugeordnet ist.

Das der Energieversorgungseinrichtung 34 zugeordnete Belagselement 1 kann als "Anschlussdiele" bezeichnet werden. Eine "Leiterdiele" kann durch das weitere Belagselement 20 gebildet werden, das zur Übertragung von elektrischer Energie und/oder elektrischer Ladung und/oder Informationen ausgebildet sein kann.

Sofern das Belagselement 1 einen Drucksensor der Messeinrichtung 26 aufweist, ist - wie vorstehend erläutert - vorgesehen, dass an der Trägerschicht 21 Leiterbahnen 27 angeordnet sind. Bei dem System 33 ist somit eine Verbindung der Leiterbahnen 27 des Belagselementes 1 und der Leiterbahnen 27 der weiteren Belagselemente 20 vorgesehen, wie dies schematisch die Fig. 7 bis 15 zeigen.

Nicht dargestellt ist, dass der Funktionsschicht 3 wenigstens eine, insbesondere externe, Bedienungseinrichtung zur Steuerung der Funktionsschicht 3 und/der zur Steuerung der Messeinrichtung 26 zugeordnet ist.

Ferner ist nicht dargestellt, dass der Funktionsschicht 3, der Messeinrichtung 26 und/oder der Verarbeitungseinrichtung 28 eine, insbesondere externe, Steuereinrichtung zugeordnet ist. Die Funktionsschicht 3, die Messeinrichtung 26 und/oder die Verarbeitungseinrichtung 28 können durch die Steuereinrichtung steuerbar und/oder regelbar ausgebildet sein.

Außerdem ist nicht dargestellt, dass der Funktionsschicht 3 eine Negativmaskenschicht zum Ausgleich von überstehenden Konturen zugeordnet ist.

Fig. 18 zeigt darüber hinaus ein System 33, wobei wenigstens ein Belagselement 1 mit einer Steuereinrichtung 40 verbunden ist. Über die Steuereinrichtung 40 kann ein, insbesondere akustisches und/oder visuelles, Signal abgegeben werden. Dieses Signal kann beispielsweise zeitlich zu dem Zeitpunkt ausgesendet werden, wenn auf der Nutzseite 4 des Belages 35 eine Person gestürzt ist und/oder wenn eine Person das die Messeinrichtung 26 aufweisende Belagselement 1 betritt.

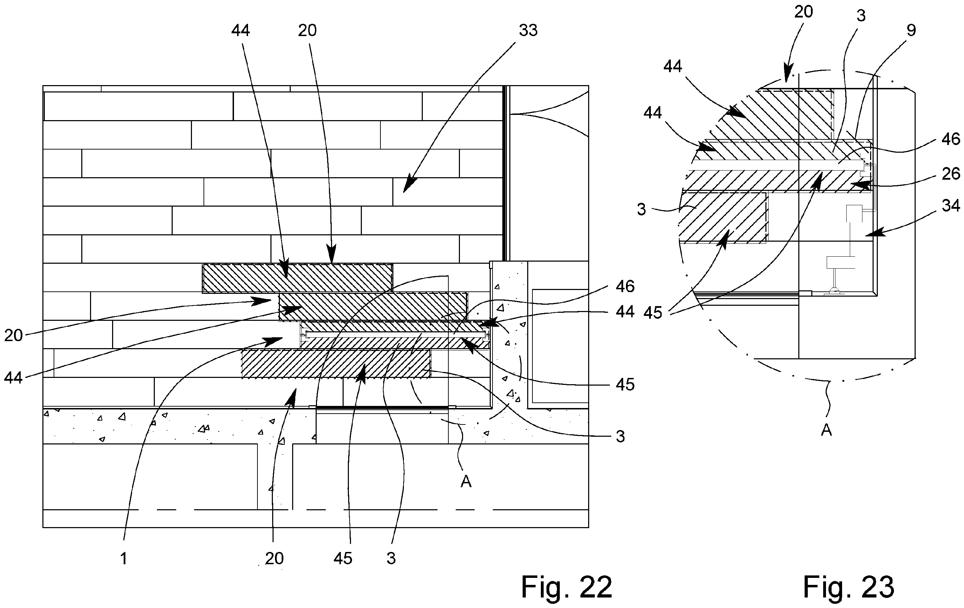

Fig. 22 zeigt ein System 33, das ein Belagselement 1 ("Anschlussdiele") und weitere Belagselemente 20 ("Leiterdielen") aufweist. Schematisch angedeutet ist, dass das Belagselement 1 als Teil eines Fußbodenbelag 35 eingesetzt wird. Das Belagselement 1 bzw. die Funktionsschicht 3 des Belagselementes 1 weist einen kapazitiven Sensor der Messeinrichtung 26 auf. In dem dargestellten Ausführungsbeispiel weist die Funktionsschicht 3 des Belagselementes 2 wenigstens zwei elektrisch geladene Bereiche - dargestellt durch entsprechende Schraffuren - auf, die gemeinsam - zumindest mittelbar - zumindest im Wesentlichen vollflächig die Unterseite 7 der Trägerplatte 2 bedecken.

Der elektrisch positiv geladene Bereich 44 der Funktionsschicht 3 ist durch einen isolierenden Trennbereich 46 von dem elektrisch negativ geladenen Bereich 45 der Funktionsschicht elektrisch getrennt.

Das weitere Belagselement 20 weist entweder einen positiv geladenen Bereich 44 oder einen negativ geladenen Bereich 45 als Funktionsschicht 3 auf - abhängig davon, an welchen Bereich der Funktionsschicht 3 des Belagselementes 1 das weitere Belagselement 20 angeordnet wird. Im dargestellten Ausführungsbeispiel ist vorgesehen, dass jeweils an einer Längsseite 9 der elektrisch positiv geladene Bereich 44 und der elektrisch negativ geladene Bereich 45 angrenzt.

Fig. 23 zeigt das Detail A aus Fig. 22. An das Belagselement 1 und insbesondere an die Funktionsschicht 3 des Belagselementes 1 ist eine Energieversorgungseinrichtung 34, insbesondere ein Netzteil, angeordnet, die das Belagselement 1 mit positiver oder negativer elektrischer Ladung versorgt. Diese Ladung kann dann an die weiteren Belagselemente 20 ("Leiterdielen") weitergegeben werden.

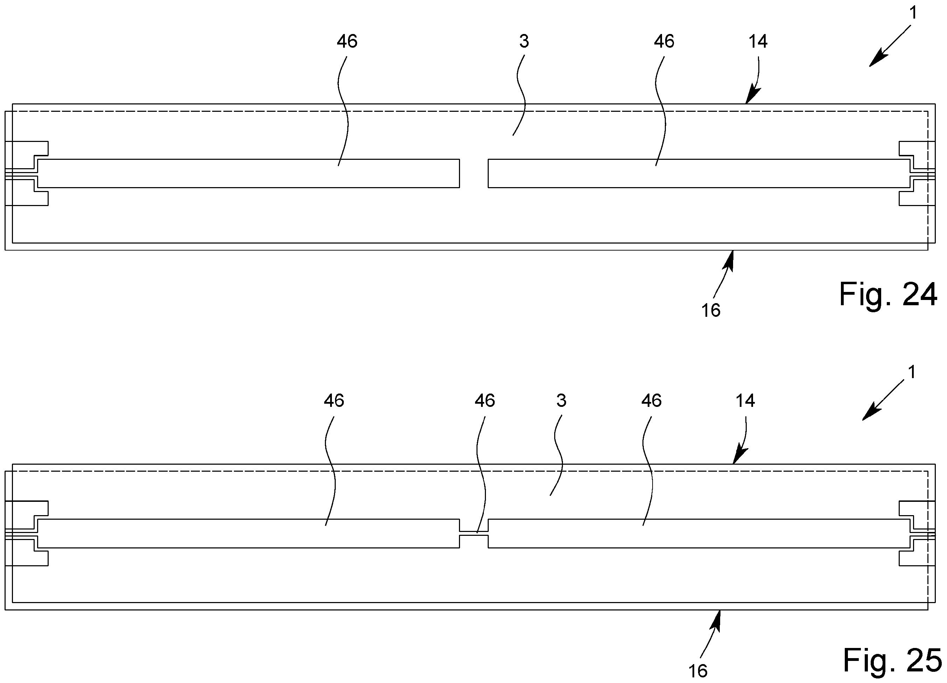

Die Fig. 24 und 25 betreffen eine Ausführungsform, bei der die Messeinrichtung 26 der Funktionsschicht 3 einen kapazitiven Sensor aufweist. Letztlich ist es in den dargestellten Ausführungsformen so, dass sich die Sensorfläche des kapazitiven Sensor zumindest im Wesentlichen vollflächig über die Funktionsschicht 3 erstreckt. In Fig. 24 sind wenigstens zwei elektrisch isolierende Trennbereiche 46 vorgesehen. Die Trennbereiche 46 sind im dargestellten Ausführungsbeispiel zumindest im Wesentlichen rechteckförmig ausgebildet.

Das in Fig. 24 gezeigte Belagselement 1 kann insbesondere als weiteres Belagselement 20 in einem System 33 genutzt werden, wobei an das weitere Belagselement 20 keine Energieversorgungseinrichtung 34 angeordnet werden muss. Letztlich stellt das in Fig. 24 dargestellte Belagselement 1 eine "Leiterdiele" dar, die als weiteres Belagselement 20 in einem System 33 einsetzbar ist.

Fig. 25 zeigt eine Modifikation des in Fig. 24 gezeigten Belagselementes 1, wobei die zwei elektrisch isolierenden Trennbereiche 46 zu einem elektrisch isolierenden Trennbereich 46 zusammengeführt worden sind. In dem dargestellten Ausführungsbeispiel ist ein schmaler, die Trennbereiche 46 verbindender Steg vorgesehen. Das in Fig. 25 dargestellte Belagselement 1 kann in einem System 33 als Belagselement 1 eingesetzt werden, das letztlich eine "Anschlussdiele" bilden kann. Der Trennbereich 46 des in Fig. 25 dargestellten Belagselementes 1 ist derart ausgebildet, das zwei verschieden elektrisch geladene Bereiche der Funktionsschicht 3 voneinander elektrisch trennbar sind. Der elektrisch isolierende "Steg" kann beispielsweise durch ein Messer, insbesondere Cuttermesser, in die Funktionsschicht 3 eingebracht werden, insbesondere wobei zumindest teilweise die Funktionsschicht 3 entfernt wird. Diese Ausführungsformen sind besonders vorteilhaft, da so in einem System 33 eingesetzte "Anschlussdielen" (Belagselemente 1) und "Leiterdielen" (weitere Belagselemente 20) einheitlich produzierbar und lagerbar sind.

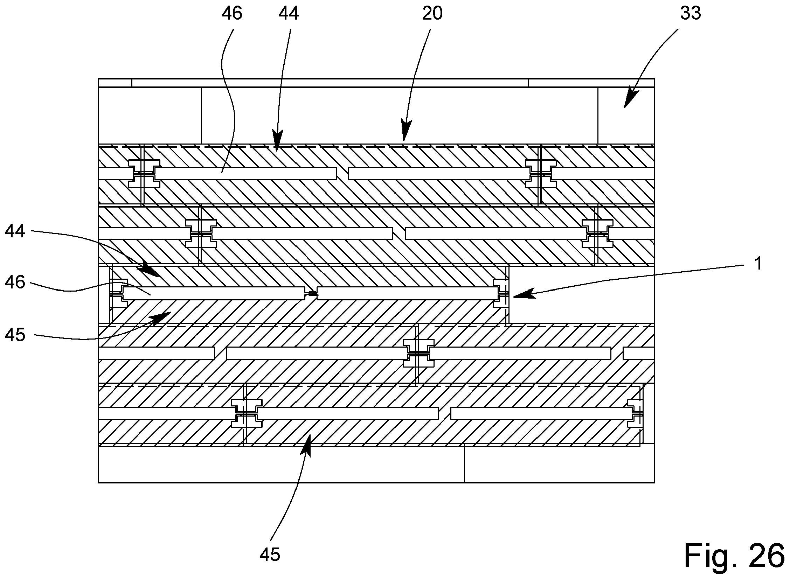

Fig. 26 zeigt die in den Fig. 24 und 25 dargestellten Belagselemente 1 in einem System 33, wobei das in Fig. 24 dargestellte Belagselement 1 als weiteres Belagselement 20 ("Leiterdiele") und das in Fig. 25 dargestellte Belagselement 1 als Belagselement 1 ("Anschlussdiele") eingesetzt wird. Das Belagselement 1 weist einen elektrisch positiv geladenen Bereich 44 der Funktionsschicht 3 und einen elektrisch negativ geladenen Bereich 45 der Funktionsschicht 3 auf. Das Belagselement 1 ist an eine nicht dargestellte Energieversorgungseinrichtung 34 angeschlossen.

An die positiv und negativ geladenen Bereich 44, 45 sind jeweils positiv und negativ geladene Bereiche 44, 45 der weiteren Belagselemente 20 angeordnet. Die weiteren Belagselemente 20 weisen entweder nur einen positiv geladenen oder einen negativ geladenen Bereich 44, 45 auf. Die elektrisch geladenen Bereiche 44, 45 sind letztlich vollflächig als Sensorflächen eines kapazitiven Sensors der Messeinrichtung 26 ausgebildet.

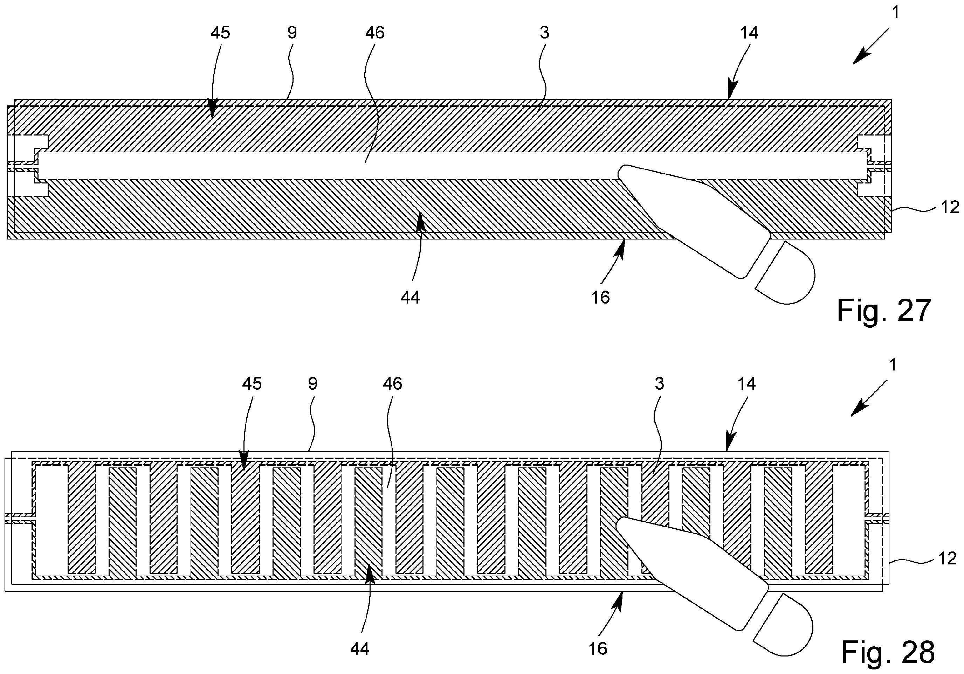

In Fig. 27 ist schematisch ein Belagselement 1 gezeigt, das eine Funktionsschicht 3 aufweist, die zumindest im Wesentlichen vollflächig an der Unterseite 7 der Trägerplatte 2 - zumindest mittelbar - angeordnet ist. Die Funktionsschicht 3 weist eine Messeinrichtung 26 auf, die im dargestellten Ausführungsbeispiel wiederum einen kapazitiven Sensor aufweist. Die Sensorfläche des kapazitiven Sensors erstreckt sich zumindest im Wesentlichen über die gesamte Funktionsschicht 3. Die Sensorfläche wird durch einen elektrisch positiv geladenen Bereich 44 und einen elektrisch negativ geladenen Bereich 45 gebildet, die letztlich die Messeinrichtung 26 der Funktionsschicht 3 ausmachen. Die elektrisch geladenen Bereiche 44, 45 sind durch einen elektrisch isolierenden Trennbereich 46 voneinander elektrisch getrennt. Schematisch ist dargestellt, dass eine Person das Belagselement 1 betritt.

Fig. 28 zeigt schematisch eine weitere Ausführungsform des kapazitiven Sensors der Messeinrichtung 26 der Funktionsschicht 3. Die Funktionsschicht 3 weist einen elektrisch positiv geladenen Bereich 44 und einen elektrisch negativ geladenen Bereich 45 auf, die voneinander über einen zumindest im Wesentlichen linienförmigen und wellenförmigen bzw. stufenförmigen Trennbereich 46 elektrisch getrennt sind. So wird ermöglicht, dass wenn eine Person das Belagselement 1 betritt, der Fuß der Person sowohl auf einem positiv geladenen Bereich 44 und einen elektrisch negativ geladenen Bereich 45 trifft. Die so ausgeübte Kapazitätsänderung kann durch die Messeinrichtung 26 detektiert werden.

Schematisch ist in den Fig. 24 bis 27 die Nutseite 14 und die Federseite 16 durch einen "Versatz" der Oberseite und der Unterseite des Belagselementes 1 dargestellt.

Nicht dargestellt ist, dass wenn die Messeinrichtung 26 einen kapazitiven Sensor aufweist, die Funktionsschicht 3 elektrisch neutrale Flächen aufweisen kann. Alternativ oder zusätzlich kann nur eine elektrisch geladene Fläche (positiv oder negativ) vorgesehen sein, die zur Detektion einer Kapazitätsänderung mit einer weiteren elektrisch geladenen Fläche bzw. Bereich der Auswerteeinrichtung 42 zusammenwirken kann. In diesem Zusammenhang kann vorgesehen sein, dass innerhalb eines Systems 33 das den kapazitiven Sensor aufweisende Belagselement 1 nur eine elektrisch positiv oder negativ geladene Funktionsschicht 3 bzw. Sensorfläche aufweist.

Nicht dargestellt ist, dass ein Verfahren zur Herstellung eines Belagselementes 1 nach einer der zuvor beschriebenen Ausführungsformen vorgesehen ist. Das Verfahren weist die folgenden Schritte auf:
A) Einbringen einer Nut-Feder-Verbindungsgeometrie 11 in eine Trägerplatte 2, insbesondere zur Ausbildung einer Klickverbindung;
B) Anbringen einer Funktionsschicht 3 unterseitig der Trägerplatte 2, wobei die Funktionsschicht 3 derart an die Trägerplatte 2 angeordnet wird, dass die Funktionsschicht 3 an wenigstens einer Seite 8, insbesondere an wenigstens einer Längsseite 9, im Einbauzustand des Belagselementes 1 über den Seitenrand 10 der Seite 8, insbesondere der Längsseite 9, übersteht;
wobei der Verfahrensschritt B) nachfolgend zu dem Verfahrensschritt A) durchgeführt wird.

Bei dem nicht dargestellten Verfahren kann vorgesehen sein, dass vor dem Verfahrensschritt A) oder nach dem Verfahrensschritt A), insbesondere vor Durchführung des Verfahrensschrittes B), an der Oberseite der Trägerplatte 2 wenigstens ein, vorzugsweise mehrlagiger, Schichtaufbau 37 angeordnet wird. Der Schichtaufbau 37 kann fest mit der Trägerplatte 2 verbunden werden. Der Schichtaufbau 37 kann dabei eine Verschleißschicht, eine Dekorschicht 43 und/oder eine Deckschicht aufweisen.

Der mehrlagige Schichtaufbau 37 und/oder die Lagen des mehrlagigen Schichtaufbaus 37 können insbesondere auf die Trägerplatte 2 aufkaschiert werden. Alternativ oder zusätzlich kann vorgesehen sein, dass eine Echtholzdeckschicht 38 durch eine Schutzschicht und/oder Versiegelung, die oberseitig auf die Echtholzdeckschicht 38 aufgebracht wird, geschützt wird.

Alternativ oder zusätzlich kann auch vorgesehen sein, dass der Schichtaufbau 37 mit der Trägerplatte 2 verpresst wird.

Insbesondere wird der Verfahrensschritt B) nach dem Aufkaschieren und/oder Verpressen des Schichtaufbaus 37 und der Trägerplatte 2 durchgeführt.

Bei einer weiteren Ausführungsform des nicht dargestellten Verfahrens wird die Nut-Feder-Verbindungsgeometrie 11 in die Seiten 8 des Belagselementes 1, insbesondere der Trägerplatte 2, eingefräst, eingeprägt und/oder eingeschnitten.

Darüber hinaus kann bei einer weiteren Ausgestaltung des nicht dargestellten Verfahrens nachfolgend zu dem Verfahrensschritt B) die Funktionsschicht 3 zumindest abschnittsweise an wenigstens einem Seitenrand 10, insbesondere an einer Federseite 16, nach unten - d.h. der Trägerplatte 2 abgewandt - umgelegt und/oder umgefaltet werden.

Weiter ist nicht dargestellt, dass vor dem Verfahrensschritt B) oder nach Durchführung des Verfahrensschrittes B) wenigstens eine Aussparung, insbesondere Ausfräsung, unterseitig in die Trägerplatte 2 eingebracht wird. Die Aussparung kann in die Trägerplatte 2 eingeschnitten, eingefräst und/oder eingeprägt werden. Zudem kann die Aussparung zur Aufnahme eines elektronischen Bauteils vorgesehen sein.

### Bezugszeichenliste:

- 1: Belagselement
- 2: Trägerplatte
- 3: Funktionsschicht
- 4: Nutzseite
- 5: Oberseite
- 6: Untergrund
- 7: Unterseite
- 8: Seite
- 9: Längsseite
- 10: Seitenrand
- 11: Nut-Feder-Verbindungsgeometrien
- 12: Querseite
- 13: Nut
- 14: Nutseite
- 15: Feder
- 16: Federseite
- 17: überstehender Bereich
- 18: Kontaktierungsfläche
- 19: weitere Kontaktierungsfläche
- 20: weiteres Belagselement
- 21: Trägerschicht
- 22: eingeklappter und/oder umgefalteter Bereich
- 23: Oberseite von 21
- 24: Unterseite von 21
- 25: Verbindungsmittel
- 26: Messeinrichtung
- 27: Leiterbahn
- 28: Verarbeitungseinrichtung
- 29: Informationsübertragungsleitung
- 30: Informationsübertragungsschnittstelle
- 31: Kontaktierungsbereich
- 32: Gegenzug
- 33: System
- 34: Energieversorgungseinrichtung
- 35: Belag
- 36: isolierter Bereich
- 37: mehrlagiger Schichtaufbau
- 38: Echtholzdeckschicht
- 39: Schutzschicht
- 40: Steuereinrichtung
- 41: Übertragungseinrichtung
- 42: Auswerteeinrichtung
- 43: Dekorschicht
- 44: elektrisch positiv geladener Bereich von 3
- 45: elektrisch negativ geladener Bereich von 3
- 46: Trennbereich

## Patentansprüche

1. Belagselement (1), vorgesehen zur Verwendung als Boden-, Wand- und/oder Deckenbelagselement für einen Boden-, Wand- und/oder Deckenbelag, mit wenigstens einer Trägerplatte (2) und wenigstens einer Funktionsschicht (3), wobei die Trägerplatte (2) eine einer Nutzseite (4) zugewandte Oberseite (5) und eine der Oberseite (5) gegenüberliegende, dem Untergrund (6) zugewandte Unterseite (7) aufweist,
wobei die Funktionsschicht (3) unterhalb der Trägerplatte (2) vorgesehen ist und wobei die Funktionsschicht (3) derart ausgebildet ist, dass sie an wenigstens einer Seite (8), insbesondere an wenigstens einer Längsseite (9), im Einbauzustand über den Seitenrand (10) der Seite (8), insbesondere der Längsseite (9), übersteht,
**dadurch gekennzeichnet,**
**dass** die Funktionsschicht (3) auf einer an der Unterseite (7) der Trägerplatte (2) angeordneten Trägerschicht (21) angeordnet ist und
**dass** an der Trägerschicht (21) wenigstens zwei Leiterbahnen (27) der Funktionsschicht (3) angeordnet sind.

2. Belagselement nach Anspruch 1, **dadurch gekennzeichnet, dass** an gegenüberliegenden Seiten (8) der Trägerplatte (2) korrespondierende Nut-Feder-Verbindungsgeometrien (11), insbesondere zur Ausbildung einer Klickverbindung, mit einer eine Nut (13) aufweisenden Nutseiten (14) und einer der Nutseite (14) gegenüberliegenden, eine Feder (15) aufweisenden Federseite (16) vorgesehen sind, wobei die Funktionsschicht (3) über den Seitenrand (10) der Nutseite (14) im Einbauzustand übersteht und/oder dass an gegenüberliegenden Seiten (8) der Trägerplatte (2) korrespondierende Druckknopf- und/oder Bajonettverbindungsgeometrien vorgesehen sind.

3. Belagselemente nach Anspruch 1 oder 2, **dadurch gekennzeichnet, dass** die Funktionsschicht (3) in ihrem im Einbauzustand überstehenden Bereich (17) zumindest bereichsweise wenigstens eine Kontaktierungsfläche (18) aufweist, die elektrisch kontaktierend und/oder elektrisch leitend und/oder induktiv koppelbar ausgebildet ist, und dass die Funktionsschicht (3) auf der der Kontaktierungsfläche (18) gegenüberliegenden Seite (8) des Belagselementes eine weitere Kontaktierungsfläche (19) aufweist, die elektrisch kontaktierend und/oder elektrisch leitend und/oder induktiv koppelbar ausgebildet ist.

4. Belagselement nach Anspruch 3, **dadurch gekennzeichnet, dass** die Kontaktierungsfläche (18) und die weitere Kontaktierungsfläche (19) derart korrespondierend zueinander ausgebildet sind, dass die Kontaktierungsfläche (18) des Belagselementes (1) im Einbauzustand mit einer weiteren Kontaktierungsfläche (19) eines weiteren, mit dem Belagselement (1) verbundenen Belagselement (20) elektrisch leitend verbunden ist und/oder induktiv gekoppelt ist und wobei, vorzugsweise, die Kontaktierungsfläche (18) zumindest bereichsweise unmittelbar angrenzend an die weitere Kontaktierungsfläche (19) des weiteren Belagselementes (20) im Einbauzustand angeordnet ist.

5. Belagselement nach einem der vorhergehenden Ansprüche, **dadurch gekennzeichnet, dass** die Funktionsschicht (3) fest mit der Trägerschicht (21) verbunden ist und/oder dass die Funktionsschicht (3) aus der Trägerschicht (21) besteht.

6. Belagselement nach einem der vorhergehenden Ansprüche, **dadurch gekennzeichnet, dass** auf der Trägerschicht (21) wenigstens eine Messeinrichtung (26) der Funktionsschicht (3), vorzugsweise ein Sensor, insbesondere ein Drucksensor und/oder ein kapazitiver Sensor, angeordnet, insbesondere aufgedruckt, ist, insbesondere wobei die Messeinrichtung (26) fest mit der Trägerschicht (21) verbunden ist und/oder wobei die Messeinrichtung (26) zur Erfassung einer auf das Belagselement (1) wirkenden Druckänderung und/oder Kapazitätsänderung ausgebildet ist und/oder zur Ermittlung der Temperatur und/oder der Feuchtigkeit ausgebildet ist.

7. Belagselement nach einem der vorhergehenden Ansprüche, **dadurch gekennzeichnet, dass** an der Trägerschicht (21) wenigstens zwei Leiterbahnen (27) der Funktionsschicht (3) aufgedruckt worden sind, insbesondere wobei die Trägerschicht (21) einseitig oder beidseitig Leiterbahnen (27) aufweist.

8. Belagselement nach einem der vorhergehenden Ansprüche, **dadurch gekennzeichnet, dass** die Leiterbahnen (27), insbesondere in wenigstens einer Kontaktierungsfläche (18) und/oder in wenigstens einer weiteren Kontaktierungsfläche (19), zumindest bereichsweise elektrisch isoliert sind, vorzugsweise durch einen Lack.

9. Belagselement nach einem der vorhergehenden Ansprüche, **dadurch gekennzeichnet, dass** die Leiterbahnen (27) derart in wenigstens einer Kontaktierungsfläche (18) und/oder in wenigstens einer weiteren Kontaktierungsfläche (19) angeordnet sind, dass sie im Einbauzustand des Belagselementes (1) mit den jeweiligen Leiterbahnen (27) eines mit dem Belagselement (1) verbundenen weiteren Belagselementes (20) elektrisch leitend verbunden und/oder induktiv gekoppelt sind, insbesondere wobei die Leiterbahnen (27) des Belagselementes (1) mit den Leiterbahnen (27) des weiteren Belagselementes (20) überlappend angeordnet sind.

10. Belagselement nach einem der vorhergehenden Ansprüche, **dadurch gekennzeichnet, dass** der Funktionsschicht (3) und/oder der Messeinrichtung (26) eine Verarbeitungseinrichtung (28) zugeordnet ist, insbesondere in der Funktionsschicht (3) vorgesehen ist, insbesondere wobei die Verarbeitungseinheit (28) zur Verarbeitung der von der Messeinrichtung (26) aufgenommenen Informationen ausgebildet ist.

11. Belagselement nach einem der vorhergehenden Ansprüche, **dadurch gekennzeichnet, dass** die Messeinrichtung (26) und/oder die Verarbeitungseinrichtung (28) mit wenigstens einer Informationsübertragungsleitung (29) zur Übertragung der durch die Messeinrichtung (26) aufgenommen, insbesondere durch die Verarbeitungseinrichtung (28) verarbeiteten, Informationen verbunden ist, insbesondere wobei wenigstens eine Informationsübertragungsschnittstelle (30) in wenigstens einem Kontaktierungsbereich (31), insbesondere in der Kontaktierungsfläche (18) und/oder der weiteren Kontaktierungsfläche (19), angeordnet ist, insbesondere so dass die Informationen über die Informationsübertragungsschnittstelle (30) an ein weiteres Belagselement (20) übertragbar sind und/oder wobei die Informationen über die Informationsübertragungsschnittstelle (30) kabellos übertragbar sind.

12. Belagselement nach einem der vorhergehenden Ansprüche, **dadurch gekennzeichnet, dass** der Unterseite (7) der Trägerplatte (2) zugewandt ein Gegenzug (32), insbesondere ein Kraftpapier, angeordnet ist, insbesondere wobei die Funktionsschicht (3) zwischen dem Gegenzug (32) und der Trägerplatte (2), vorzugsweise unmittelbar an der Trägerplatte (2), und/oder unterhalb des Gegenzugs (32) angeordnet ist und/oder wobei die Funktionsschicht (3) den Gegenzug (32) bildet.

13. System (33) mit einer Mehrzahl von Belagselementen (1), wobei wenigstens ein Belagselement (1) nach einem der vorhergehenden Ansprüche ausgebildet ist, wobei das Belagselement (1) mit weiteren Belagselementen (20) zur Bildung eines Belags (35) verbunden ist.

14. System nach Anspruch 13, **dadurch gekennzeichnet, dass** der Funktionsschicht (3) eine, vorzugsweise externe, Energieversorgungseinrichtung (34) zugeordnet ist, insbesondere wobei durch die Energieversorgungseinrichtung (34) die Funktionsschicht (3) mit Energie versorgbar ist, insbesondere wobei die Energieversorgungseinrichtung (34) elektrisch leitend mit der Funktionsschicht (3) verbunden ist und/oder induktiv mit der Funktionsschicht (3) gekoppelt ist.

15. Verfahren zur Herstellung eines Belagselementes (1) nach einem der Ansprüche 1 bis 12, wobei das Verfahren die folgenden Schritte aufweist:
A) Einbringen einer Nut-Feder-Verbindungsgeometrie (11) in eine Trägerplatte (2), insbesondere zur Ausbildung einer Klickverbindung;
B) Anbringen einer auf einer Trägerschicht (21) angeordneten Funktionsschicht (3) unterseitig der Trägerplatte (2), wobei die Funktionsschicht (2) derart an die Trägerplatte (2) angeordnet wird, dass die Funktionsschicht (2) an wenigstens einer Seite (8), insbesondere an wenigstens einer Längsseite (9), im Einbauzustand des Belagselementes (1) über den Seitenrand (10) der Seite (8), insbesondere der Längsseite (9), übersteht;
wobei der Verfahrensschritt B) nachfolgend zu dem Verfahrensschritt A) durchgeführt wird.

## Claims

1. Surface element (1), intended for use as a floor, wall and/or ceiling surface element for a floor, wall and/or ceiling covering, having at least one carrier plate (2) and at least one functional layer (3), wherein the carrier plate (2) has a top side (5) facing a usable side (4) and an underside (7) opposite the top side (5) and facing the underground (6),
wherein the functional layer (3) is provided underneath the carrier plate (2) and wherein the functional layer (3) is designed in such a way that in the installed state it projects beyond the side edge (10) of the side (8), in particular of the long side (9), on at least one side (8), in particular on at least one long side (9),
**characterized in that**
the functional layer (3) is arranged on a support layer (21) arranged on the underside (7) of the carrier plate (2), and
**in that** at least two conductor paths (27) of the functional layer (3) are arranged on the support layer (21).

2. Surface element according to claim 1, **characterized in that** on opposite sides (8) of the carrier plate (2) corresponding tongue-and-groove joint geometries (11) are provided, in particular for forming a click connection, with a groove side (14) having a groove (13) and a tongue side (16) having a tongue (15) opposite the groove side (14), wherein the functional layer (3) projects beyond the side edge (10) of the groove side (14) in the installed state, and/or **in that** corresponding snap fastener and/or bayonet connection geometries are provided on opposite sides (8) of the carrier plate (2).

3. Surface elements according to claim 1 or 2, **characterized in that** the functional layer (3) has, in its region (17) projecting in the installed state, at least in some regions, at least one contacting area (18) which is designed to be electrically contacting and/or electrically conductive and/or inductively couplable, and **in that** the functional layer (3) has, on the side (8) of the surface element opposite the contacting area (18), a further contacting area (19) which is designed to be electrically contacting and/or electrically conductive and/or inductively couplable.

4. Surface element according to claim 3, **characterized in that** the contacting area (18) and the further contacting area (19) are designed to correspond to one another in such a way that, in the installed state, the contacting area (18) of the surface element (1) is electrically conductively connected and/or inductively coupled to a further contacting area (19) of a further surface element (20) connected to the surface element (1) and wherein, preferably, the contacting area (18) is arranged at least in regions directly adjacent to the further contacting area (19) of the further surface element (20) in the installed state.

5. Surface element according to one of the preceding claims, **characterized in that** the functional layer (3) is firmly connected to the support layer (21) and/or **in that** the functional layer (3) consists of the support layer (21).

6. Surface element according to one of the preceding claims, **characterized in that** at least one measuring device (26) of the functional layer (3), preferably a sensor, in particular a pressure sensor and/or a capacitive sensor, is arranged, in particular printed, on the support layer (21), in particular the measuring device (26) being firmly connected to the support layer (21) and/or the measuring device (26) being designed to detect a change in pressure and/or a change in capacitance acting on the surface element (1) and/or being designed to determine the temperature and/or the humidity.

7. Surface element according to one of the preceding claims, **characterized in that** at least two conductor paths (27) of the functional layer (3) have been printed on the support layer (21), in particular the support layer (21) having conductor paths (27) on one side or both sides.

8. Surface element according to one of the preceding claims, **characterized in that** the conductor paths (27), in particular in at least one contacting area (18) and/or in at least one further contacting area (19), are electrically insulated at least in regions, preferably by a lacquer.

9. Surface element according to one of the preceding claims, **characterized in that** the conductor paths (27) are arranged in at least one contacting area (18) and/or in at least one further contacting area (19) in such a way that in the installed state of the surface element (1) they are electrically conductively connected and/or inductively coupled to the respective conductor paths (27) of a further surface element (20) connected to the surface element (1), in particular wherein the conductor paths (27) of the surface element (1) are arranged overlapping with the conductor paths (27) of the further surface element (20).

10. Surface element according to one of the preceding claims, **characterized in that** a processing device (28) is assigned to the functional layer (3) and/or the measuring device (26), in particular is provided in the functional layer (3), in particular wherein the processing device (28) is designed for processing the information recorded by the measuring device (26).

11. Surface element according to one of the preceding claims, **characterized in that** the measuring device (26) and/or the processing device (28) is connected to at least one information transmission path (29) for transmitting the information picked up by the measuring device (26), in particular processed by the processing device (28), in particular wherein at least one information transmission interface (30) is arranged in at least one contacting area (31), in particular in the contacting area (18) and/or the further contacting area (19), in particular in such a way that the information can be transmitted to a further surface element (20) via the information transmission interface (30) and/or wherein the information can be transmitted wirelessly via the information transmission interface (30).

12. Surface element according to one of the preceding claims, **characterized in that** a countermove (32), in particular a kraft paper, is arranged facing the underside (7) of the carrier plate (2), in particular wherein the functional layer (3) is arranged between the countermove (32) and the carrier plate (2), preferably directly on the carrier plate (2), and/or below the countermove (32), and/or the functional layer (3) forming the countermove (32).

13. System (33) comprising a plurality of surface elements (1), wherein at least one surface element (1) is formed according to any one of the preceding claims, wherein the surface element (1) is connected to further surface elements (20) to form a coating (35).

14. System according to claim 13, **characterized in that** the functional layer (3) is assigned a, preferably external, power supply device (34), in particular wherein the functional layer (3) can be supplied with energy by the power supply device (34), in particular wherein the power supply device (34) is electrically conductively connected to the functional layer (3) and/or inductively coupled to the functional layer (3).

15. Method of manufacturing a surface element (1) according to any one of claims 1 to 12 , wherein the method comprises the following steps:
A) providing of a tongue-and-groove joint geometry (11) into a carrier plate (2), in particular for forming a click connection;
B) applying a functional layer (3) arranged on a support layer (21) on the underside of the carrier plate (2), wherein functional layer (2) is arranged on the carrier plate (2) in such a way that the functional layer (2) projects on at least one side (8), in particular on at least one long side (9), beyond the side edge (10) of the side (8), in particular of the long side (9), in the installed state of the surface element (1);
wherein process step B) is carried out subsequently to process step A).

## Revendications

1. Elément de surface (1), prévu pour être utilisé comme élément de surface de sol, de mur et/ou de plafond pour un revêtement de sol, de mur et/ou de plafond, comprenant au moins une plaque de support (2) et au moins une couche fonctionnelle (3), dans lequel la plaque de support (2) présente une face supérieure (5) tournée vers un côté utilisable (4) et une face inférieure (7) opposée à la face supérieure (5) et tournée vers le sous-sol (6),
dans lequel la couche fonctionnelle (3) est prévue sous la plaque de support (2) et dans lequel la couche fonctionnelle (3) est conçue de telle sorte qu'elle dépasse sur au moins un côté (8), en particulier sur au moins un côté long (9), au-delà du bord latéral (10) du côté (8), en particulier du côté long (9), à l'état monté,
**caractérisé en ce que**
la couche fonctionnelle (3) est disposée sur une couche de support (21) disposée sur la face inférieure (7) de la plaque de support (2), et
**en ce qu'**au moins deux pistes conductrises (27) de la couche fonctionnelle (3) sont disposés sur la couche de support (21).

2. Elément de surface selon la revendication 1, **caractérisé en ce que** sur des côtés (8) opposés de la plaque de support (2) sont prévues des géométries d'assemblage à rainure et languette (11) correspondantes, en particulier pour former une liaison par encliquetage, avec un côté rainure (14) présentant une rainure (13) et un côté languette (16) présentant une languette (15) opposée au côté rainure (14), la couche fonctionnelle (3) dépassant, à l'état monté, du bord latéral (10) du côté rainure (14), et/ou **en ce que** des géométries correspondantes de connexion par bouton-poussoir et/ou baïonnette sont prévues sur des côtés opposés (8) de la plaque de support (2).

3. Eléments de surface selon la revendication 1 ou 2, **caractérisés en ce que** la couche fonctionnelle (3) présente, dans sa zone (17) faisant saillie à l'état monté, au moins par endroits, au moins une zone de contact (18) qui est conçue pour être en contact électrique et/ou conductrice d'électricité et/ou couplable par induction, et **en ce que** la couche fonctionnelle (3) présente, sur le côté (8) de l'élément de surface opposé à la zone de contact (18), une autre zone de contact (19) qui est conçue pour être en contact électrique et/ou conductrice d'électricité et/ou couplable par induction.

4. Elément de surface selon la revendication 3, **caractérisé en ce que** la zone de contact (18) et l'autre zone de contact (19) sont conçues pour correspondre l'une à l'autre de telle sorte que, à l'état monté, la zone de contact (18) de l'élément de surface (1) est reliée de manière électriquement conductrice et/ou couplée par induction à une autre zone de contact (19) d'un autre élément de surface (20) relié à l'élément de surface (1) et dans lequel, de préférence, la zone de contact (18) est disposée au moins dans des zones directement adjacentes à l'autre zone de contact (19) de l'autre élément de surface (20) à l'état monté.

5. Elément de surface selon l'une des revendications précédentes, **caractérisé en ce que** la couche fonctionnelle (3) est reliée solidement à la couche de support (21) et/ou que la couche fonctionnelle (3) est constituée de la couche de support (21).

6. Elément de surface selon l'une des revendications précédentes, **caractérisé en ce qu'**au moins un dispositif de mesure (26) de la couche fonctionnelle (3), de préférence un capteur, en particulier un capteur de pression et/ou un capteur capacitif, est disposé, en particulier imprimé, sur la couche support (21), le dispositif de mesure (26) étant en particulier relié fixement à la couche support (21) et/ou le dispositif de mesure (26) étant conçu pour détecter une variation de pression et/ou une variation de capacité agissant sur l'élément de surface (1) et/ou étant conçu pour déterminer la température et/ou l'humidité.

7. Elément de surface selon l'une des revendications précédentes, **caractérisé en ce qu'**au moins deux pistes conductrices (27) de la couche fonctionnelle (3) ont été imprimées sur la couche support (21), en particulier la couche support (21) présentant des pistes conductrices (27) sur une face ou sur les deux faces.

8. Elément de surface selon l'une des revendications précédentes, **caractérisé en ce que** les pistes conductrices (27), en particulier dans au moins une zone de contact (18) et/ou dans au moins une autre zone de contact (19), sont isolées électriquement au moins par zones, de préférence par une laque.

9. Elément de surface selon l'une des revendications précédentes, **caractérisé en ce que** les pistes conductrices (27) sont disposées dans au moins une zone de contact (18) et/ou dans au moins une autre zone de contact (19) de telle sorte qu'à l'état monté de l'élément de surface (1), elles sont reliées de manière électriquement conductrice et/ou couplées de manière inductive aux pistes conductrices (27) respectives d'un autre élément de surface (20) relié à l'élément de surface (1), en particulier, les pistes conductrices (27) de l'élément de surface (1) étant disposées de manière à se chevaucher avec les pistes conductrices (27) de l'autre élément de surface (20).

10. Elément de surface selon l'une des revendications précédentes, **caractérisé en ce qu'**un dispositif de traitement (28) est associé à la couche fonctionnelle (3) et/ou au dispositif de mesure (26), en particulier est prévu dans la couche fonctionnelle (3), le dispositif de traitement (28) étant en particulier conçu pour traiter les informations enregistrées par le dispositif de mesure (26).

11. Elément de surface selon l'une des revendications précédentes, **caractérisé en ce que** le dispositif de mesure (26) et/ou le dispositif de traitement (28) est relié à au moins une voie de transmission d'informations (29) pour transmettre les informations captées par le dispositif de mesure (26), en particulier traitées par le dispositif de traitement (28), en particulier dans lequel au moins une interface de transmission d'informations (30) est disposée dans au moins une région de contact (31), en particulier dans la zone de contact (18) et/ou l'autre zone de contact (19), en particulier de telle sorte que les informations peuvent être transmises à un autre élément de surface (20) par l'intermédiaire de l'interface de transmission d'informations (30) et/ou que les informations peuvent être transmises sans fil par l'intermédiaire de l'interface de transmission d'informations (30).

12. Elément de surface selon l'une des revendications précédentes, **caractérisé en ce qu'**un contre-mouvement (32), en particulier un papier kraft, est disposé en regard de la face inférieure (7) de la plaque de support (2), en particulier dans lequel la couche fonctionnelle (3) est disposée entre le contre-mouvement (32) et la plaque de support (2), de préférence directement sur la plaque de support (2), et/ou sous le contre-mouvement (32), et/ou la couche fonctionnelle (3) formant le contre-mouvement (32).

13. Système (33) comprenant une pluralité d'éléments de surface (1), dans lequel au moins un élément de surface (1) est formé selon l'une quelconque des revendications précédentes, dans lequel l'élément de surface (1) est relié à d'autres éléments de surface (20) pour former un revêtement (35).

14. Système selon la revendication 13, **caractérisé en ce qu'**un dispositif d'alimentation en énergie (34), de préférence externe, est associé à la couche fonctionnelle (3), en particulier la couche fonctionnelle (3) pouvant être alimentée en énergie par le dispositif d'alimentation en énergie (34), en particulier le dispositif d'alimentation en énergie (34) étant relié de manière électriquement conductrice à la couche fonctionnelle (3) et/ou couplé de manière inductive à la couche fonctionnelle (3).

15. Procédé de fabrication d'un élément de surface (1) selon l'une quelconque des revendications 1 à 12 , dans lequel le procédé comprend les étapes suivantes :
A) insérer d'une géométrie d'assemblage à rainure et languette (11) dans une plaque de support (2), en particulier pour former un assemblage par encliquetage ;
B) Application d'une couche fonctionnelle (3) disposée sur une couche de support (21) sur la face inférieure de la plaque de support (2), la couche fonctionnelle (3) étant disposée sur la plaque de support (2) de telle sorte que la couche fonctionnelle (3) fait saillie sur au moins un côté (8), en particulier sur au moins un côté long (9), au-delà du bord latéral (10) du côté (8), en particulier du côté long (9), dans l'état monté de l'élément de surface (1) ;
dans lequel l'étape B) du procédé est réalisée après l'étape A) du procédé.
